(19) **Europäisches Patentamt**
**European Patent Office**
**Office européen des brevets**

(11) **EP 3 317 931 B1**

(12) **EUROPÄISCHE PATENTSCHRIFT**

(45) Veröffentlichungstag und Bekanntmachung des Hinweises auf die Patenterteilung:
**27.08.2025   Patentblatt 2025/35**

(21) Anmeldenummer: **16708698.2**

(22) Anmeldetag: **09.03.2016**

(51) Internationale Patentklassifikation (IPC):
*H01S 5/12* (2021.01)      *H01S 5/20* (2006.01)

(52) Gemeinsame Patentklassifikation (CPC):
**H01S 5/1225; H01S 5/1231; H01S 5/2086**

(86) Internationale Anmeldenummer:
**PCT/EP2016/055019**

(87) Internationale Veröffentlichungsnummer:
**WO 2017/001062 (05.01.2017 Gazette 2017/01)**

(54) **LASERDIODE MIT VERTEILTER RÜCKKOPPLUNG UND VERFAHREN ZUR HERSTELLUNG**

LASER DIODE HAVING DISTRIBUTED FEEDBACK AND METHOD FOR PRODUCTION

DIODE LASER AVEC RÉTROCOUPLAGE DISTRIBUÉ ET PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.06.2015   DE 102015110515**

(43) Veröffentlichungstag der Anmeldung:
**09.05.2018   Patentblatt 2018/19**

(73) Patentinhaber: **Ferdinand-Braun-Institut gGmbH, Leibniz-Institut für Höchstfrequenztechnik 12489 Berlin (DE)**

(72) Erfinder:
• **FRICKE, Jörg**
  **10319 Berlin (DE)**

• **ERBERT, Götz**
  **02708 Löbau (DE)**
• **CRUMP, Paul**
  **10245 Berlin (DE)**
• **DECKER, Jonathan**
  **12437 Berlin (DE)**

(74) Vertreter: **Gulde & Partner Patent- und Rechtsanwaltskanzlei mbB Berliner Freiheit 2 10785 Berlin (DE)**

(56) Entgegenhaltungen:
**JP-A- H10 223 967     US-B1- 6 577 660**

EP 3 317 931 B1

**Beschreibung**

Die Erfindung betrifft eine Laserdiode mit verteilter Rückkopplung und ein Verfahren zur Herstellung. Insbesondere betrifft die vorliegende Erfindung eine Laserdiode und ein Verfahren zur Herstellung bei der die verteilte Rückkopplung über ein Oberflächengitter hoher Ordnung bei vorzugsweise einseitiger Strahlungsauskopplung erfolgt und bei der die Kopplungsstärke des Gitters an die Leistungsdichte der in der Laserdiode geführten Welle angepasst ist.

Technologischer Hintergrund der Erfindung

Bei Laserdioden mit verteilter Rückkopplung (im Englischen als Distributed Feedback oder DFB Laser Diode bezeichnet) handelt es sich um monolithisch aufgebaute, frequenzstabilisierte Laserlichtquellen. Im Gegensatz zu Diodenlasern mit einer externer Kavität oder DBR (Distributed Bragg-Reflector) Laserdioden ist bei Laserdioden mit verteilter Rückkopplung das frequenzselektive Element monolithisch mit dem Laserresonator verbunden und steht mit diesem bereits bei der Strahlungserzeugung in Wechselwirkung. Bei dem frequenzselektiven Element handelt es sich für gewöhnlich um ein in unmittelbarer Nähe der aktiven Schicht befindliches Bragg-Gitter, welches als Oberflächengitter ausgeführt ist und das mit dem erzeugten Strahlungsfeld direkt wechselwirkt.

Der wesentliche Vorteil von Laserdioden mit verteilter Rückkopplung ist deren monolithischer Aufbau, durch welchen ein kompakter und stabiler Diodenlaseraufbau realisiert werden kann. Durch Verbesserungen im Design und bei der Materialqualität gab es in den letzten Jahren immense Fortschritte bei der Umsetzung solcher Diodenlaserkonzepte, so dass insbesondere im Bereich der Hochleistungslaserdioden durch die Verwendung von Breitstreifenlaserdioden inzwischen optische Ausgangleistungen von weit über einem Watt realisiert werden können.

Um eine möglichst schmalbandige Laseremission zu erreichen, ist eine starke Wechselwirkung des Gitters mit dem optischen Feld notwendig. Ein solches stark wechselwirkendes Gitter reduziert jedoch die Effizienz der Auskopplung und erhöht die optischen Verluste innerhalb des Resonators. Daher stehen eine hohe Ausgangsleistung bzw. eine hohe elektro-optische Konversionseffizienz im Allgemeinen einer geringen Linienbreite der Laserdiode entgegen. Die Stärke der Gitterwechselwirkung muss daher sehr genau an das Laserfeld angepasst werden um ein Optimum zwischen beiden Parametern zu erzielen.

Beim Design von Laserdioden mit verteilter Rückkopplung muss der Einfluss des Gitters so gering wie möglich gehalten werden, da oftmals bereits ein kleiner Anstieg des elektrischen Widerstands der Stromzuführung oder der auftretenden optischen Absorption zu einem Einbruch der Laserperformance führen kann. Vorteilhaft ist weiterhin die Verwendung von Gittern hoher Ordnung ($N \geq 10$), da hierdurch die Anforderungen an die Prozessierung, insbesondere an die Lithografie, reduziert werden können.

Bei der Herstellung von Laserdioden mit verteilter Rückkopplung, die auf solchen Gittern hoher Ordnung basieren, sind jedoch die zulässigen Fertigungstoleranzen für die Erzeugung der notwendigen Gittertiefe extrem klein. Zudem ist es vorteilhaft, wenn im Bereich hoher optischer Leistungsdichte der Einfluss des Gitters reduziert wird, um damit die Verluste im Resonator zu reduzieren und eventuell auftretenden Sättigungseffekten, beispielsweise dem longitudinalen Lochbrennen, entgegenzuwirken.

Für schmalbandige Laserdioden kommt als ein weiteres Kriterium der im Betrieb erreichbare Locking-Bereich hinzu. Der Locking-Bereich gibt an, wie weit die Bragg-Wellenlänge des Gitters und das Gewinnmaximum der aktiven Schicht auseinander liegen dürfen, ohne die spektrale Linienbreite (95% Leistungseinschluss) zu vergrößern. Dieser Abstand wird auch als Detuning ($\Delta\lambda_{det}$) bezeichnet. Eine Abstimmung des Detuning erfolgt meist über die Temperatur der Laserdiode. Bei Laserdioden mit verteilter Rückkopplung entsprechend dem Stand der Technik (Crump et al., J. Phys. D: Appl. Phys. 46 (2013) 013001; Decker et al., IEEE Photon. Technol. Lett. 27 (2015) 1675) werden mit uniformen Gittern für das Verhältnis zwischen optischer Ausgangsleitung und Betriebsstrom bei Raumtemperatur typischerweise elektro-optische Leistungsanstiege S von 0.9 W/A gemessen. Dort sind beispielsweise erfolgreich Linienbreiten unter 1 nm ($\pm 2\sigma$-Bereich) in einem thermalen Abstimmfenster von bis zu 35 K ($\Delta\lambda_{det} \approx 10$ nm) demonstriert worden. Bei uniformen Gittern sind die Parameterbereiche jedoch im Allgemeinen bereits vollständig ausgereizt und weitgehend optimiert, so dass eine weitere Verbesserung des thermischen Abstimmverhaltens nur zu Lasten der Konversions- bzw. Auskoppeleffizienz der Laserdiode erreicht werden kann.

Aus der US 6 577 660 B1 ist ein Halbleiterlaser mit verteilter Rückkopplung bekannt, der einen graduell ansteigenden Kopplungskoeffizienten aufweist. Die JP H10 223967 A offenbart einen Halbleiterlaser mit verteilter Rückkopplung, bei dem in der Längsrichtung des Resonators zumindest die Breite der aktiven Schicht, die Materialzusammensetzung einer Führungsschicht oder der Abstand zwischen der Führungsschicht und der aktiven Schicht variiert wird.

Der Erfindung liegt daher die Aufgabe zugrunde, eine Laserdiode mit verteilter Rückkopplung zur Verfügung zu stellen, bei der eines oder mehrere der geschilderten Probleme des Standes der Technik vermieden oder zumindest deutlich gemindert werden können. Insbesondere sollen eine Laserdiode und ein Verfahren zur Herstellung bereitgestellt werden, bei der die verteilte Rückkopplung über ein Oberflächengitter hoher Ordnung bei vorzugsweise einseitiger Strahlungsauskopplung erfolgt und bei der die Kopplungsstärke des Gitters an die Leistungsdichte der in der Laserdiode geführten Welle angepasst ist.

Zusammenfassung der Erfindung

Die genannte Aufgabe wird durch eine Laserdiode nach Anspruch 1 und einem Verfahren zur Herstellung einer solchen Laserdiode nach Anspruch 14 gelöst. Dabei umfasst die Laserdiode eine aktive Schicht; einen die aktive Schicht zumindest teilweise umgebenden wellenführenden Bereich; eine Rückfacette; eine zur Auskopplung von Laserstrahlung ausgelegte Frontfacette, wobei sich die aktive Schicht zumindest teilweise entlang einer ersten Achse zwischen der Rückfacette und der Frontfacette erstreckt; und ein Gitter, das mit dem wellenführenden Bereich wirkverbunden ist, wobei das Gitter eine Vielzahl von Stegen und Gräben umfasst, wobei es sich um ein Oberflächengitter handelt und die Ordnung des Gitters im Bereich zwischen 10 und 100 liegt. Die Vielzahl der Gräben ist derart ausgebildet, dass ein mittlerer Anstieg eines Kopplungsparameters $P$ für die Vielzahl der Gräben entlang des Gitters ungleich Null ist. Hierbei ist der Kopplungsparameter $P$ eines Grabens durch die Formel $P = \Delta n / w d_{res}$ definiert, wobei $d_{res}$ ein Abstand des Grabens zur aktiven Schicht, $w$ eine Breite des Grabens und $\Delta n = |n - n_M|$ der Brechzahlunterschied (auch als Brechzahlkontrast bzw. Brechungsindexkontrast bezeichnet) zwischen der Brechzahl $n$ des Grabens und der Brechzahl $n_M$ eines den Graben umgebenden Materials ist. Als Abstand des Grabens zur aktiven Schicht gilt dabei der minimale Abstand zwischen der der aktiven Schicht zugewandten Seite des jeweiligen Grabens und der diesem Graben zugewandten Seite der aktiven Schicht.

Der eingeführte Kopplungsparameter dient als Unterscheidungs- und Ordnungsmerkmal für die Stärke der Wechselwirkung des Gitters mit einer parallel zu der ersten Achse im wellenführenden Bereich geführten Welle. Der Kopplungsparameter beschreibt daher einen allgemeinen generalisierten Zusammenhang zwischen den Eigenschaften eines Gitters und der Stärke der Wechselwirkung mit einer Welle, ohne dabei jedoch Bezug auf die spezifischen physikalischen Eigenschaften der Welle zu nehmen.

In einem weiteren Aspekt dieser Erfindung umfasst die Laserdiode eine aktive Schicht; einen die aktive Schicht zumindest teilweise umgebenden wellenführenden Bereich; eine Rückfacette; eine zur Auskopplung von Laserstrahlung ausgelegte Frontfacette, wobei sich die aktive Schicht zumindest teilweise entlang einer ersten Achse zwischen der Rückfacette und der Frontfacette erstreckt; und ein Gitter, das mit dem wellenführenden Bereich wirkverbunden ist, wobei das Gitter eine Vielzahl von Stegen und Gräben umfasst. Die Erfindung ist dadurch gekennzeichnet, dass die Vielzahl der Gräben derart ausgebildet ist, dass ein mittlerer Anstieg eines Kopplungsparameters $P$ für die Vielzahl der Gräben ungleich Null ist, wobei der Kopplungsparameter P eines Grabens durch die Formel $P = w \cdot d \cdot n$ definiert ist, wobei $d$ eine Tiefe des Grabens oder ein Abstand des Grabens zur aktiven Schicht, $w$ eine Breite des Grabens und $n$ eine Brechzahl des Grabens ist. Es handelt sich hierbei um eine alternative Definition eines Kopplungsparameters $P$. Die sich aus den verschiedenen Definitionen ergebenden Werten lassen sich ineinander umrechnen.

Die Festlegung eines Kopplungsparameters P stellt keine allgemein gültige Messvorschrift dar. Diese ist vielmehr dazu gedacht, eine Vergleichbarkeit der Kopplungsstärke einzelner Gräben innerhalb einer gemeinsamen Gitteranordnung zu ermöglichen. Daher kann sich die verwendete Mittelwertdefinition bzw. die jeweilige Festlegung eines Tiefen-, Breite- und Brechungsindexmaßes nach praktischen Gesichtspunkten durchaus zwischen verschieden Gittern unterscheiden; innerhalb einer einzelnen Gitterstruktur hat jedoch eine eindeutige Festlegung zu erfolgen. Zur Bestimmung der Einzelparameter (Tiefen oder Abstände, Breite und Brechungsindex bzw. Brechungsindexkontrast eines Grabens des Gitters) sowie des mittleren Anstiegs des Kopplungsparameters vorzugsweise das arithmetische Mittel verwendet. Dies ist insbesondere dann von Bedeutung, wenn die Wände der Gräben, beispielsweise durch ein stufenweises anisotropes Ätzverfahren, unterschiedliche Randprofile aufweisen. Für eine eindeutige Bestimmung der einzelnen Parameterwerte wird hierbei die Notwendigkeit einer entsprechenden Mittelung offensichtlich.

Bei den Gittern lassen sich aufgrund ihrer Abmessungen im Wesentlichen zwei Arten oder Regime unterscheiden. Gitter, welche durch Teile der Wellenleiterstruktur von der Halbleiteroberfläche geätzt werden, weisen in der Regel einen relativ starken Brechzahlunterschied $\Delta n$ zum umgebenden wellenführenden Bereich auf und werden als Oberflächengitter bezeichnet. Bei solchen Gittern wird die physikalische Gitterstärke, d.h. die tatsächliche Stärke der Wechselwirkung zwischen dem Gitter und der im wellenführenden Bereich geführten Welle, typischerweise über den Gesamtreflexionsgrad R der Gitterstruktur bestimmt (Decker et al., IEEE Photon. Technol. Lett. 27 (2015) 1675). Durch die Verwendung des Gesamtreflexionsgrad R berücksichtigt man bei Oberflächengittern, dass die vertikale Mode in den geätzten Bereichen so stark deformiert wird, dass die Kopplung in longitudinaler Richtung nicht vom Modenprofil entkoppelt ist. Der Reflektionsgrad R muss daher aufwendig mit numerischen Verfahren (z.B. Mode Matching) berechnet werden. Im Unterschied dazu stehen Gitter, welche durch einen zweiten Epitaxieschritt in den Wellenleiter eingebettet werden. Diese eingebetteten Gitter weisen meist nur einen relativ schwachen Brechzahlkontrast zum umgebenden Material bzw. zum wellenführenden Bereich auf. Die vertikale Mode ist in diesem Fall in der Gitterregion nahezu unverändert. Bei solchen vergrabenen Gittern wird die physikalische Gitterstärke typischerweise nicht über den Gesamtreflexionsgrad R der Gitterstruktur sondern stattdessen mithilfe des dazu äquivalenten Koppelfaktor-Länge-Pro-

dukts $\kappa L$ bestimmt (Crump et al., J. Phys. D: Appl. Phys. 46 (2013) 013001). Dieses Produkt beschreibt die über das Gitter vermittelte lokale Kopplung zwischen den in Vorwärts- und Rückwärtsrichtung propagierenden geführten Wellen. Zur Herstellung der überwachsenen Gitter müssen das Epitaxiewachstum unterbrochen, die Gitter definiert (z.B. mittels e-Beam) und anschließend überwachsen werden. Üblicherweise werden solche Gitterstrukturen als vergrabene Gitter bezeichnet.

Der Erfindung liegt die Erkenntnis zugrunde, dass im Bereich hoher optischer Leistungsdichte zur Verringerung der auftretenden Verluste im Resonator und zur Vermeidung von Sättigungseffekten, beispielsweise dem longitudinalen Lochbrennen, die Stärke der Gitterwechselwirkung reduziert werden muss. Aus theoretischen Untersuchungen (Crump et al., J. Phys. D: Appl. Phys. 46 (2013) 013001) ist bekannt, dass sich insbesondere bei konventionellen Breitstreifen-Hochleistungslaserdioden mit verteilter Rückkopplung in longitudinaler Richtung entlang der optischen Achse eine nicht homogene Verteilung der optischen Leistung einstellt. Bei einseitiger Auskopplung der Laserstrahlung tritt dabei vor allem der Fall ein, dass die Leistungsdichte innerhalb der Laserdiode in Richtung der Auskopplungsfacette kontinuierlich ansteigt. Der genaue funktionelle Zusammenhang hängt dabei vom spezifischen Design der Laserdiode ab, kann aber in aller Regel durch einfache mathematische Funktionen (linear, exponentiell, hyperbolisch, ...) zumindest angenähert werden. Auch zur Reduzierung der Empfindlichkeit des Gitters gegenüber bei der Herstellung technisch nicht zu vermeidenden Schwankungen, beispielsweise in der Ätztiefe bei der Erzeugung von Gräben, ist eine Variation der Kopplungsstärke des Gitters vorteilhaft. Dadurch kann bei geeigneter Wahl des Kopplungsstärkeabfalls sichergestellt werden, dass das Gitter zumindest in Teilbereichen eine ausreichend hohe Reflektivität bzw. Kopplungsstärke aufweist.

Eine Anpassung der Kopplungsstärke des Gitters an die optische Leistungsdichte innerhalb einer Laserdiode mit verteilter Rückkopplung führt zu einer erfindungsgemäßen Laserdiode mit einem Gitter, bei dem der Kopplungsparameter des Gitters im Wesentlichen umgekehrt proportional zur optischen Leistungsdichte innerhalb der Laserdiode ist. Insbesondere führt eine Anpassung der Kopplungsstärke des Gitters an die optische Leistungsdichte damit zu einer Laserdiode mit verteilter Rückkopplung, bei dem der Kopplungsparameter von der Rück- zur Frontfacette entlang der Resonatorachse kontinuierlich abnimmt. Dies kann beispielsweise dadurch geschehen, dass entsprechend der zugrunde liegenden Proportionalitätsverhältnisse entweder die Tiefe benachbarter Gräben entlang dieser Achse abnimmt, oder die Breite der Gräben entlang dieser Achse abnimmt, oder die Brechzahl der Gräben entlang dieser Achse abnimmt.

Bei dem verwendeten Gitter handelt es sich um ein Oberflächengitter, wobei die Ordnung des Gitters im Bereich zwischen 10 und 100 liegt. Durch die Verwendung eines solchen Gitters hoher Ordnung werden die Abstände zwischen den einzelnen Gitterelementen, d.h. zwischen den Gräben, bezogen auf die von der Laserdiode emittierte Laserwellenlänge, erheblich aufgeweitet und somit die Anforderungen an die Genauigkeit der Prozessierung verringert.

Während der Kopplungsparameter $P$ eines Grabens eine lokale Maßzahl für die Stärke der Wechselwirkung eines Gitterelements mit einer im wellenführenden Bereich geführten Welle darstellt, kann über eine weitere Bestimmungsgröße, die sogenannte Apodisierungsmaßzahl $A$, auch die Wirkung des Gitters als Ganzes beschrieben werden. Aus der in Anspruch 1 genannten Bedingung, dass ein mittlerer Anstieg des Kopplungsparameters $P$ für die Vielzahl der Gräben ungleich null ist, folgt das Vorhandensein eines maximalen und eines minimalen Wertes für den Kopplungsparameter $P$ der Vielzahl der Gräben des Gitters entlang der ersten (longitudinalen) Achse zwischen Rückfacette und Frontfacette der erfindungsgemäßen Laserdiode. Das durch

$$A_P = \frac{Maximum\{P\}}{Minimum\{P\}}$$

angegebene Verhältnis ist daher, neben dem mittleren Anstieg des Kopplungsparameters $P$, dazu geeignet, die Wirkung des Gitters als Ganzes zu beschreiben.

Die angegebene Formel zur Bestimmung der Apodisierungsmaßzahl $A_P$ basiert auf rein geometrischen und optischen Eigenschaften der einzelnen Gräben und berücksichtigt jedoch nicht die spezifische Wechselwirkung der geführten Welle mit dem Gitter. Zwar werden die grundlegenden physikalischen Zusammenhänge vorzeichenrichtig erfasst, eine allgemeine Proportionalitätsbeziehung ist daraus jedoch nicht unmittelbar herleitbar. Um die Proportionalität der Wechselwirkung ebenfalls mit berücksichtigen zu können, kann stattdessen die physikalische Gitterstärke herangezogen werden.

Hierbei können insbesondere folgende Bestimmungsgrößen herangezogen werden: (1) Der lokale Reflektionsgrad $R(x)$ und (2) das Koppelfaktor-Länge-Produkt $\kappa L(x)$ des Gitters, jeweils in Abhängigkeit von der longitudinalen Position $x$. Da der Reflektionsgrad $R$ und das Koppelfaktor-Länge-Produkt $\kappa L$ eines einzelnen Gitterstegs im Gitter nicht sinnvoll berechnet werden können, wird stattdessen die Reflektivität $R$ bzw. das Koppelfaktor-Länge-Produkt $\kappa L$ am Punkt $x$ mit der Reflektivität eines entsprechenden, virtuellen, uniformen Gitters, welches sich über die gesamte Kavitätslänge erstreckt, berechnet. Da die Reflektivität $R$ bzw. das Koppelfaktor-Länge-Produkt $\kappa L$ eines Gitters wellenlängenabhängig ist, werden stets die jeweiligen Maximalwerte zugrunde gelegt. Je nach vorliegendem Gitterregime lassen sich dann von zwei uniformen Gitter gleichen Typs mit jeweils minimaler und maximaler Kopplungsstärke der Gesamtreflexionsgrad

$R_{max}$ der Gitterstrukturen bzw. das Koppelfaktor-Länge-Produkte $\kappa L$ bestimmen und miteinander ins Verhältnis setzen.

Bei einer erfindungsgemäßen Variation des Kopplungsparameter $P$ durch lokale Änderung entlang der ersten Achse an den Stellen $x$ folgt somit eine alternative Formulierung der Apodisierungsmaßzahl als

$$A_R = \frac{Maximum\{R(x)\}}{Minimum\{R(x)\}} \ \text{ bzw. } \ A_{\kappa L} = \frac{Maximum\{\kappa L(x)\}}{Minimum\{\kappa L(x)\}}.$$

Über den lokalen Reflexionsgrad $R(x)$ bzw. das Koppelfaktor-Länge-Produkt $\kappa L(x)$ können hierbei auch direkte Rückschlüsse auf den proportionalen Einfluss der einzelnen Bestimmungsgrößen des Gitters, insbesondere der Tiefe $d$ (bzw. dem Abstand des Grabens zur aktiven Schicht $d_{res}$), der Breite $w$ und der Brechzahl $n$ der einzelnen Gräben des Gitters bzw. deren jeweiligen Brechzahlkontrast, gezogen werden.

Werden nun insbesondere der lokale Reflexionsgrad $R(x)$ bzw. das Koppelfaktor-Länge-Produkt $\kappa L(x)$ erfindungsgemäß entlang der Resonatorachse der Laserdiode variiert, so ergibt sich eine bevorzugte Apodisierungsmaßzahl $A$ von größer oder gleich 1.1. Weiterhin bevorzugt sind Apodisierungsmaßzahlen $A$ von größer oder gleich 1.2, größer oder gleich 1.3, größer oder gleich 2, sowie größer oder gleich 3. Dabei sind für eine Variation der Gitterstärke vorzugsweise ein arbiträrer funktioneller Zusammenhang, eine monoton steigende Erhöhung, eine lineare Erhöhung, oder eine quadratische Erhöhung entlang der longitudinalen Achse besonders bevorzugt. Die Erhöhung kann dabei sowohl von der Front- zur Rückfacette als auch von der Rück- zur Frontfacette gerichtet sei. Besonders bevorzugt ist ein funktioneller Zusammenhang, bei dem die Kopplung des Gitters so an die optische Leistungsdichte der parallel zu der longitudinalen Achse im wellenführenden Bereich geführten Welle angepasst ist, dass sich dadurch entlang dieser Achse eine gleichbleibende Wechselwirkung mit der Welle ergibt.

In einer bevorzugten Ausgestaltung der Erfindung ist daher vorgesehen, dass das Gitter mindestens eine Apodisierungsmaßzahl $A$ von größer oder gleich 1.1 aufweist.

Neben einer solchen globalen Definition einer Apodisierungsmaßzahl kann eine Festlegung der erfindungsgemäßen Laserdiodeneigenschaften auch über eine entsprechende Variation $V$ der einzelnen Parameter der Gräben bzw. des Gitters entlang der Gitterstruktur erfolgen. Es handelt sich hierbei um bestimmte, besonders bevorzugte Ausführungsformen einer erfindungsgemäßen Laserdiode bei der der mittlere Anstieg des Kopplungsparameters $P$ für die Vielzahl der Gräben des Gitters ungleich Null sein kann. Eine entsprechende Variation $V$ kann hierbei insbesondere über das Verhältnis des jeweiligen Maximal- und Minimalwertes des entsprechenden Parameters entlang der Gitterstruktur festgelegt werden.

Daraus ergeben sich besonders bevorzugte Ausführungsformen über die Variation $V_{dres}$ im Abstand $d_{res}$ der einzelnen Gräben zur aktiven Schicht, d.h.

$$V_{dres} = \frac{Maximum\{d_{res}\}}{Minimum\{d_{res}\}},$$

von größer oder gleich 1.1. Weiterhin bevorzugt sind Variationen $V_{dres}$ von größer oder gleich 1.2 und größer oder gleich 1.3.

Über eine Variation $V_w$ in der Breite $w$ der einzelnen Gräben können mittels einer entsprechenden Bestimmungsgleichung für die jeweiligen Parameterverhältnisses aus

$$V_w = \frac{Maximum\{w\}}{Minimum\{w\}}$$

bevorzugte Ausführungsformen für Werte von größer oder gleich 1.1, größer oder gleich 1.2 und größer oder gleich 1.3 bestimmt werden.

Für die Festlegung weiterer besonders bevorzugter Ausführungsformen ist die Variation $V_{\Delta n}$, im Brechzahlkontrast $\Delta n$ zwischen der jeweiligen Brechzahl eines Grabens und der Brechzahl des den Graben umschließenden Materials heranzuziehen. Bevorzugter Ausführungsformen ergeben sich dann mittels

$$V_{\Delta n} = \frac{Maximum\{\Delta n\}}{Minimum\{\Delta n\}}$$

bei Variationen $V_{\Delta n}$, für Werte von größer oder gleich 1.1, größer oder gleich 1.2 und größer oder gleich 1.3.

Als weiterer Variationsparameter kann der Abstand der einzelnen Gräben über die Gitterkonstante $\Lambda$ entlang des Gitters veränderlich sein, wobei für den jeweiligen effektiven Brechungsindex $n_{eff}$ eines einzelnen Grabens die Bragg-Bedingung ($\lambda_B = 2\,n_{eff}\,\Lambda\,/\,N$) für jeweils ganzzahlige $N$ erfüllt wird. Über eine Variation $V_\Lambda$ in der Gitterkonstante $\Lambda$ des Gitters, d.h. im Abstand jeweils benachbarter Gräben zueinander, können mittels einer entsprechenden Bestimmungsgleichung für die jeweiligen Parameterverhältnisses aus

$$V_\Lambda = \frac{Maximum\{\Lambda\}}{Minimum\{\Lambda\}}$$

bevorzugte Ausführungsformen für Werte von größer oder gleich 1.1, größer oder gleich 1.2 und größer oder gleich 1.3 bestimmt werden.

Bei einer erfindungsgemäßen Laserdiode kann ein arbiträrer funktioneller Zusammenhang zwischen der Gitterstärke, welche entweder global durch eine der genannten Apodisierungsmaßzahlen oder einen entsprechenden Variationsparameter beschrieben werden kann, entlang der Resonatorachse einstellt werden. Ein monotoner funktioneller Zusammenhang der Gitterstärke entlang des Resonators ist dabei besonders bevorzugt. Weiterhin bevorzugt ist ein linearer funktioneller Zusammenhang der Gitterstärke entlang des Resonators. Ebenfalls bevorzugt ist ein quadratischer funktioneller Zusammenhang der Gitterstärke entlang des Resonators. Besonders bevorzugt ist ein funktioneller Zusammenhang der Gitterstärke entlang des Resonators, der an die Leistungsdichte der in der Laserdiode geführten Welle angepasst ist, wobei in den Bereichen hoher Leistungsdichte die Gitterstärke herabgesetzt ist gegenüber der Gitterstärke in den Bereichen niedriger Leistungsdichte.

Bei einer erfindungsgemäßen Laserdiode ist die Orientierung des funktionellen Zusammenhangs der Gitterstärke entlang des Resonators frei einstellbar. Eine von der Frontfacette zur Rückfacette ansteigende Gitterstärke ist jedoch besonders bevorzugt.

Bei dem erzeugten Gitter kann es sich sowohl um ein passives, ein aktives oder ein semi-aktives Gitter handeln. Dabei deutet aktiv und passiv auf das Vorhandensein einer optischen Verstärkung im Bereich des Gitters. Findet lediglich in einzelnen Teilbereichen des Gitters eine optische Verstärkung statt, so handelt es sich um ein semi-aktives Gitter.

Bei der technischen Umsetzung einer erfindungsgemäßen Laserdiode ist eine Gitterlänge von größer oder gleich 100 $\mu$m besonders bevorzugt. Weiterhin bevorzugt ist eine Gitterlänge, die größer oder gleich 10 % der Länge des Resonators entspricht, wobei die Länge des Resonators durch den Abstand zwischen Front- und Rückfacette gegeben ist. Ebenfalls bevorzugt ist eine Gitterlänge von größer oder gleich 20 % der Länge des Resonators. Das Gitter kann zudem auch über die gesamte Länge des Resonators ausgedehnt sein. Bei einer kürzeren Gitterlänge ist die Position des Gitters entlang der ersten Achse, d.h. entlang der longitudinalen Achse bzw. der Resonatorachse, im Prinzip beliebig einstellbar. Eine Positionierung direkt an der Front- und/oder Rückfacette ist jedoch besonders bevorzugt. Ebenfalls kann das Gitter in mehrere Teilbereiche zerlegt werden. Die Teilbereiche müssen nicht zusammenhängend sein und können entlang der Resonatorachse beliebig verteilt werden. Insbesondere können auch die einzelnen Gitterteilbereiche passiv, aktiv oder semi-aktiv ausgelegt sein.

In einer weiteren bevorzugten Ausgestaltung der Erfindung ist vorgesehen, dass die erfindungsgemäße Idee der Anpassung der Kopplungsstärke des Gitters an die Leistungsdichte der im wellenführenden Bereich geführte Welle auch auf eine Achse senkrecht zur aktiven Schicht überragen werden kann. Insbesondere ist dabei eine Verjüngung der Breite der Gräben in Richtung zur aktiven Schicht vorteilhaft. Ganz besonders vorteilhaft ist dabei eine V-förmige Verjüngung der Breite der Gräben in Richtung zur aktiven Schicht.

In einer weiteren bevorzugten Ausgestaltung der Erfindung ist vorgesehen, dass die erfindungsgemäße Idee der Anpassung der Kopplungsstärke des Gitters an die Leistungsdichte der im wellenführenden Bereich geführte Welle auch entlang einer zweiten Achse, die sich senkrecht zur ersten Achse erstreckt, übertragen werden kann. Dazu wird entlang dieser Achse der Kopplungsparameter innerhalb eines Grabens als direkte Funktion der Ortes betrachtet und dieser ortsabhängige Kopplungsparameter eines Grabens an die Leistungsdichte der im wellenführenden Bereich geführten Welle angepasst, wobei in den Bereichen hoher Leistungsdichte der Wert des ortsabhängige Kopplungsparameters des Grabens herabgesetzt wird gegenüber dem Wert des ortsabhängige Kopplungsparameters des Grabens in den Bereichen niedriger Leistungsdichte.

Ein weiterer Aspekt der vorliegenden Erfindung betrifft ein Verfahren zur Herstellung einer Laserdiode mit den oben genannten Merkmalen. Die innerhalb dieses Verfahrens genutzten Methoden hängen dabei ganz wesentlich von der jeweiligen Ausführungsform der Erfindung ab und können je nach Bedarf gewählt werden. Beispielsweise können die Stege des Gitters durch eine gezielte strukturelle Veränderung eines zur Ausbildung des Gitters geeigneten Materials erzeugt werden. Möglich sind hierbei insbesondere die Implantierung von Fremdatomen mittels FIB oder Materialveränderungen beispielsweise durch die gezielte Auslösung von lokalen Kristallisations- oder Amorphisierungsprozessen. Durch eine solche Art der Prozessierung können in der Regel die den Kopplungsparameter bestimmenden Einzelparameter (Tiefe, Breite und Brechungsindex bzw. Brechzahlkontrast zur Umgebung eines Steges) und die daraus resultierende Gitterstärke entlang des Resonators (über $R_{max}(x)$ bzw. $\kappa L(x)$ bestimmt) gleichzeitig beeinflusst werden. Eine weitere Möglichkeit zur Prozessierung besteht in einer direkten Freilegung der Gräben. Dies kann insbesondere durch Anwendung eines geeigneten Ätzverfahrens erfolgen. Die dabei erzeugten Gräben weisen anschließend einen zu ihrer Umgebung, beispielsweise Luft, reduzierten Brechungsindex auf. Es ist jedoch auch möglich, durch ein anschließendes Auffüllen der Gräben mit einem weiteren Material oder Dielektrikum (z.B. durch selektives Überwachsen der Grabenwände) zusätzlich zur rein geometrischen Modifikation der Kopplungsstärke auch eine Brechungsindexveränderung zur weiteren Beeinflussung des Kopplungsparameterverlaufs zu nutzen.

Das genannte Verfahren zur Herstellung einer Laserdiode mit den oben genannten Merkmalen umfasst dabei besonders bevorzugt das Aufbringen einer Ätzmaske mit einer Vielzahl von Öffnungen auf den wellenführenden Bereich, wobei die Breite der Öffnungen entlang einer ersten Achse und/oder einer zweiten Achse örtlich variiert, und Strukturieren des maskierten wellenführenden Bereichs durch ein geeignetes Ätzverfahren. Bei diesem Ätzverfahren kann es sich bevorzugt um anisotropes reaktives Ionenätzen handeln.

Der Vorteil bei der Verwendung eines solchen Ätzverfahrens liegt in der Möglichkeit zur Ausnutzung des sogenannten Microloading-Effekts. Dieser Effekt beschreibt eine Abhängigkeit der beobachteten Ätzrate von der charakteristischen Größe einer zu ätzenden Struktur. Insbesondere bei der Erzeugung von sub-$\mu$m-Gräben ist die Ätzrate und damit die erreichbare Ätztiefe während einer vorgegebenen Ätzzeit abhängig von der Breite der Lacköffnung und der aktuellen Ätztiefe des Grabens. Bei Kenntnis der entsprechenden Zusammenhänge kann somit über die Vorgabe der Breite einer Lacköffnung eine gesteuerte Variation in der Ätztiefe erreicht werden. Durch eine gezielte Ausnutzung dieses Effektes kann eine erfindungsgemäße Anpassung der Kopplungsstärke des Gitters an die im wellenführenden Bereich geführte Welle innerhalb eines einzigen Ätzprozesses erfolgen.

Weitere bevorzugte Ausgestaltungen der Erfindung ergeben sich aus den übrigen, in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar solange die so erzeugte Merkmalskombination noch unter den in den Ansprüchen definierten Schutzumfang fällt.

Kurzbeschreibung der Figuren

Die Erfindung wird nachfolgend in Ausführungsbeispielen anhand der zugehörigen Zeichnungen erläutert. Es zeigen:

Figur 1         eine räumlich-schematische Darstellung einer Laserdiode mit verteilter Rückkopplung nach dem Stand der Technik;

Figur 2         theoretische Berechnungen zur longitudinalen Leistungsverteilung in Laserdioden mit verteilter Rückkopplung nach dem Stand der Technik;

Figur 3a, 3b    schematische Darstellungen einer bevorzugten Ausführungsform einer erfindungsgemäßen Laserdiode mit verteilter Rückkopplung;

Figur 4         drei schematische Darstellungen von bevorzugten Ausführungsformen der Gitterstruktur einer erfindungsgemäßen Laserdiode mit verteilter Rückkopplung;

Figur 5         schematische Darstellungen besonders bevorzugter Ausführungsformen der Gitterstruktur einer erfindungsgemäßen Laserdiode mit verteilter Rückkopplung;

Figur 6         schematische Darstellungen einer Ätzmaske zur Herstellung einer bevorzugten Ausführungsform einer erfindungsgemäßen Laserdiode mit verteilter Rückkopplung in Aufsicht und im Querschnitt nach dem Ätzen;

Figur 7         die experimentell erzielte Grabentiefe bei der Herstellung einer bevorzugten Ausführungsform einer erfindungsgemäßen Laserdiode mit verteilter Rückkopplung unter Anwendung einer Maske nach Figur 6;

Figur 8         schematische Darstellungen einer weiteren bevorzugten Ausführungsform einer erfindungsgemäßen Laserdiode mit verteilter Rückkopplung in Aufsicht und im Querschnitt;

| Figur 9 | eine exemplarische Leistungskurve einer herkömmlichen Laserdiode mit verteilter Rückkopplung durch ein uniformes Gitter; |

| Figur 10 | das Leistungsverhalten bevorzugter Ausführungsformen erfindungsgemäßer Laserdioden mit verteilter Rückkopplung ($A_{P1}$ = 3.0) im Vergleich zu einer herkömmlichen Laserdiode mit verteilter Rückkopplung durch ein uniformes Gitter (äquivalent mit $A_{P1}$ = 1.0); |

| Figur 11 | eine numerische Simulation zur Bestimmung des maximal erreichbaren Reflexionsgrades $R_{max}(d_{res}, w)$ einer Gitterstruktur in Abhängigkeit vom Abstand $d$ der Gräben zur aktiven Schicht und der minimalen Breite $w$ der Gräben in der Nähe zur aktiven Schicht bei einem uniformen Gitter; |

| Figur 12 | eine numerische Simulation zur Bestimmung des örtlich aufgelösten maximalen Reflexionsgrades $R_{max}(x)$ des Gitters für mehrere Ausführungsformen einer Laserdioden mit einer erfindungsgemäßen Variation der Gitterstärke. |

Detaillierte Beschreibung der Erfindung

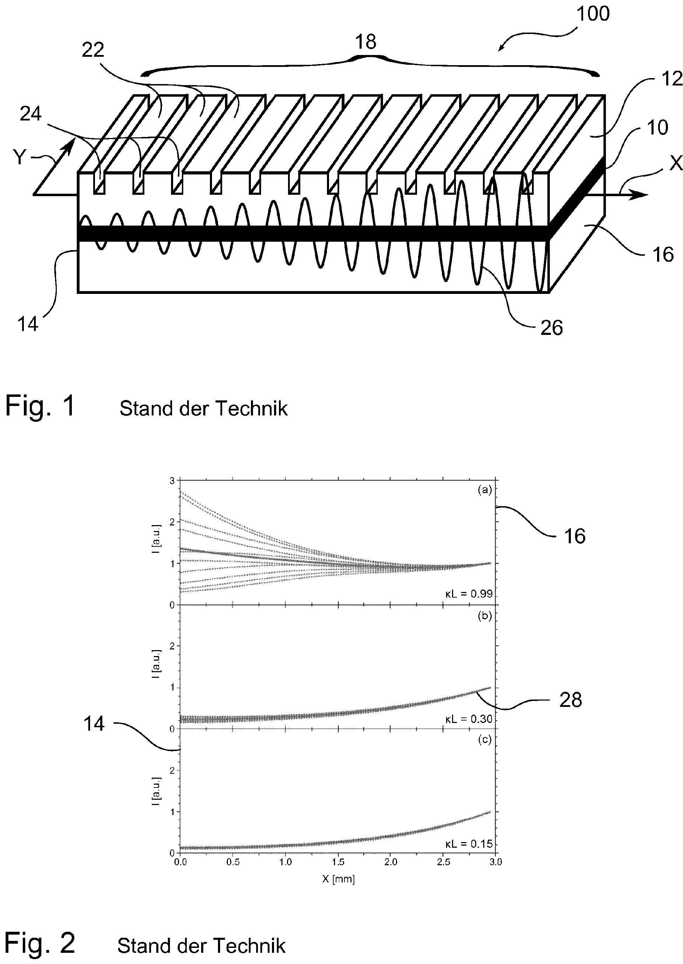

Figur 1 zeigt eine räumlich-schematische Darstellung einer Laserdiode 100 mit verteilter Rückkopplung nach dem Stand der Technik. Eine aktive Schicht 10 ist an der Ober- und Unterseite von einem direkt angrenzenden wellenführenden Bereich 12 umschlossen. Die Erzeugung und Ausbreitung der Laserstrahlung erfolgt vorzugsweise entlang einer ersten Achse X (gleichzeitig die optische Achse). Dazu senkrecht erstreckt sich parallel zur aktiven Schicht 10 eine zweite Achse Y. Die von der ersten Achse X durchstoßenen Kanten der Laserdiode 100 bilden eine Rückfacette 14 und eine Frontfacette 16 aus. Dabei erfolgt der Austritt der in der Laserdiode 100 erzeugten Laserstrahlung über die Frontfacette 12. Diese kann mit einer zusätzlich aufgebrachten Antireflexbeschichtung versehen werden. Die Rückfacette 14 wird zur Unterdrückung einer Auskopplung hingegen oftmals mit einer Verspiegelungsbeschichtung versehen. Beim Betrieb der Laserdiode baut sich zwischen der Frontfacette 12 und der Rückfacette 14 eine Welle 26 auf, welche durch den wellenführenden Bereich 12 entlang der ersten Achse X geführt wird. Innerhalb der Laserdiode 100 ergibt sich aufgrund des internen Aufbaus eine ortsabhängige Leistungsdichteverteilung. Die dabei zugrundeliegende Verteilungsfunktion hängt im Wesentlichen von den jeweiligen Dämpfungs- und Rückkopplungseigenschaften der Laserdiode 100 ab. In der Darstellung ist durch eine sich vergrößernde Amplitude der geführten Welle 26 ein Anstieg der internen Leistungsdichte in Richtung auf die Frontfacette 16 angedeutet. Bei einer Laserdiode 100 mit verteilter Rückkopplung wechselwirkt die im wellenführenden Bereich 12 geführten Welle 26 zumindest abschnittsweise mit einen Gitter 18, wobei das Gitter 18 eine Vielzahl von Stegen 22 und Gräben 24 umfasst. Über die Wechselwirkung der geführten Welle 26 mit dem Gitter 18 findet eine Frequenzselektion der erzeugten Laserstrahlung statt, so dass eine Einschränkung der Emission auf einzelne oder einige wenige Verstärkungsmoden erfolgen kann. Bei einem Gitter 18 nach dem Stand der Technik ist die Tiefe und die Breite der einzelnen Gräben 24 bis auf Fertigungstoleranzen weitgehend konstant. Daher weist ein Gitter 18 nach dem Stand der Technik in der Regel keine oder nur eine geringe örtliche Abhängigkeit der Gittereigenschaften auf. Durch die oben genannte Ortsabhängigkeit der Leistungsdichteverteilung wird jedoch die Wechselwirkung zwischen der im wellenführenden Bereich 12 geführten Welle 26 und dem Gitter 18 ebenfalls stark ortsabhängig, was sich negativ auf die Emissionseigenschaften der Laserdiode 100 auswirkt.

Figur 2 zeigt theoretische Berechnungen zur longitudinalen Leistungsverteilung in Laserdioden mit verteilter Rückkopplung nach dem Stand der Technik (Crump et al., J. Phys. D: Appl. Phys. 46 (2013) 013001). Die Abbildung zeigt die mittlere Leistungsverteilung 28 einer Laserdiode 100 mit verteilter Rückkopplung in longitudinaler Richtung entlang der einer ersten Achse X jeweils beim Schwellstrom für verschiedene Koppelfaktor-Länge-Produkte $\kappa L$ (proportional zum Kopplungsparameter) zwischen der im wellenführenden Bereich 12 geführten Welle 26 und einem entsprechenden Gitter 18 nach dem Stand der Technik. Dabei entspricht die linke Seite der Graphen einer Position auf der Rückfacette 14 der Laserdiode 100 und die rechte Seite der Graphen einer Position auf der Frontfacette 16 der Laserdiode 100. Der Abstand zwischen Rückfacette 14 und Frontfacette 16 beträgt in diesem Beispiel 3 mm. Die in den Graphen zusätzlich gestrichelt eingezeichneten Kurvenverläufe entsprechen Leistungsverteilungen unter Berücksichtigung des Einflusses eines variablen Phasenzustandes bei der Reflektion an der Rückfacette 14. Es ist zu entnehmen, dass die mittlere Leistungsverteilung 28 einer Laserdiode 100 mit verteilter Rückkopplung in longitudinaler Richtung entlang der ersten Achse X für eine Vielzahl von Fällen keinen konstanten Wert aufweist und stattdessen ein Anstieg in Richtung der Frontfacette 16 erfolgt.

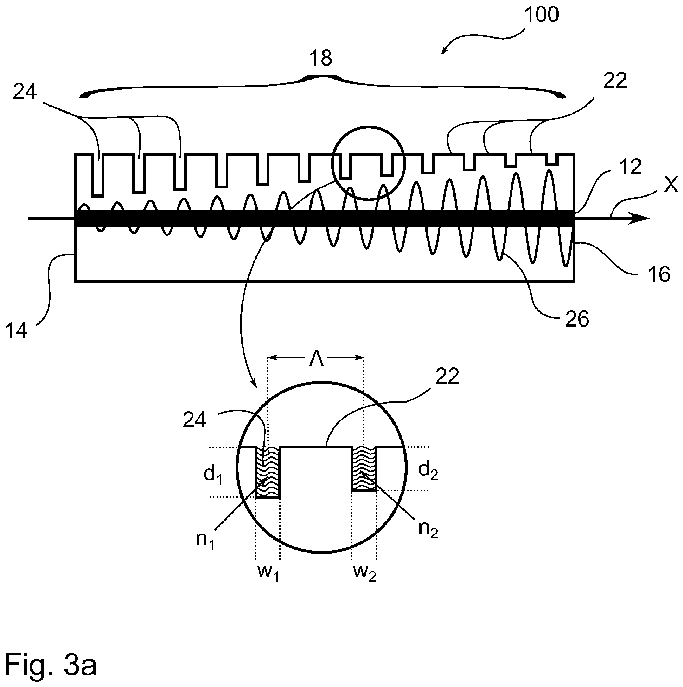

Figur 3a zeigt eine schematische Darstellung einer bevorzugten Ausführungsform einer erfindungsgemäßen Laserdiode 100 mit verteilter Rückkopplung. Die gezeigte Darstellung und die Zuordnung der einzelnen Bezugszeichen entspricht weitestgehend Figur 1. Der wesentliche Unterschied liegt jedoch im strukturellen Aufbau des Gitters 18. Dieses wurde im Gegensatz zu dem Gitter 18 in Figur 1 so modifiziert, dass eine Anpassung der Kopplung des Gitters an die Leistungsdichte der im wellenführenden Bereich 12 geführte Welle 26 ermöglicht wird. Dazu wurde in der gezeigten Ausführungsform die Tiefe d der einzelnen Gräben 24 des Gitters 18 entlang einer ersten Achse X beginnend von einer maximalen Grabentiefe $d_{max}$ in der Nähe der Rückfacette 14 hin zu einer minimalen Grabentiefe $d_{min}$ in der Nähe der Frontfacette 16 kontinuierlich reduziert. Durch die Variation der Grabentiefe d wird erreicht, dass im Bereich hoher Leistungsdichte eine verringerte Wechselwirkung zwischen der im wellenführenden Bereich 12 geführten Welle 26 und dem Gitter 18 erfolgt, während im Bereich niedriger Leistungsdichte eine verstärkte Wechselwirkung zwischen der im wellenführenden Bereich 12 geführten Welle 26 und dem Gitter 18 erfolgt. Dadurch können insbesondere Sättigungseffekte bei der Verstärkung vermieden oder zumindest verringert werden. In Figur 3a ist zur weiteren Verdeutlichung der geometrischen Eigenschaften des Gitters 18 ein Teilbereich besonders herausgestellt. Dort sind zwei nebeneinander liegende Gräben 24 gezeigt, welche durch einen Steg 22 voneinander getrennt sind. Der mittlere Abstand der Gräben entspricht dabei einer Gitterkonstante $\Lambda$, welche die zentrale Wellenlänge des Gitters 18 festlegt. Die einzelnen Gräben 24 wiederum lassen sich jeweils durch eine mittlere Breite w, eine mittlere Tiefe d und eine Brechzahl n, sowie den aus diesen Parametern resultierenden $R_{max}(x)$ und $\kappa L(x)$ beschreiben. Insbesondere kann jeder dieser drei Parameter unabhängig voneinander variiert werden, wobei eine solche Variation die Wechselwirkung zwischen der im wellenführenden Bereich 12 geführten Welle 26 und dem Gitter 18 beeinflusst. Im gezeigten Ausführungsbeispiel können jeweils die Breite w und die Brechzahl n der Gräben 24 für alle Elemente eines N-elementigen Gitters 18 als konstant angenommen werden, so dass $w_1 = w_2 = w_N$ und $n_1 = n_2 = n_N$ gilt. Die Tiefe der Gräben 24 des Gitters 18 ist hingegen zur Frontfacette 16 hin zunehmend verringert und wird daher durch eine Ungleichung $d_1 > d_2 > d_N$ beschrieben.

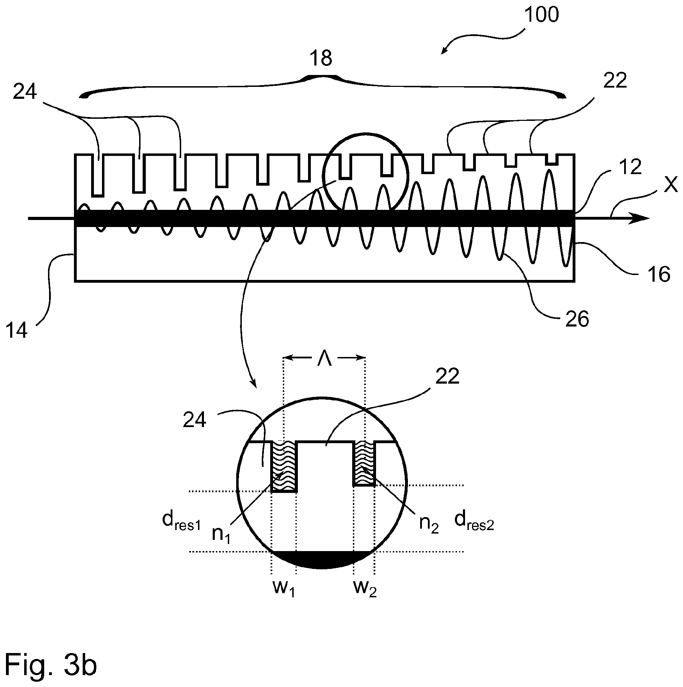

Figur 3b zeigt eine identische schematische Darstellung einer bevorzugten Ausführungsform einer erfindungsgemäßen Laserdiode 100 mit verteilter Rückkopplung. Im Gegensatz zu der in Figur 3a gezeigten Darstellung ist hier jedoch die Definition des Parameters $d_{res}$ als Abstand des Grabens 24 zur aktiven Schicht 10 dargestellt. Vorliegend ist $d_{res}$ mit d über den Abstand der Oberkante des Gitters 18 zur aktiven Schicht 10 verknüpft. Alle sonstigen Bezugszeichen und Parameter stimmen mit den in Figur 3a gezeigten Sachverhalten überein, die Beschreibung gilt entsprechend. Auch für dieses Ausführungsbeispiel kann angenommen werden, dass $w_1 = w_2 = w_N$ und $n_1 = n_2 = n_N$ gilt. Die Abstände der Gräben 24 des Gitters 18 zur aktiven Schicht 10 sind hingegen zur Frontfacette 16 hin zunehmend und werden daher vorliegend durch eine Ungleichung $d_{res1} < d_{res2} < d_{resN}$ beschrieben.

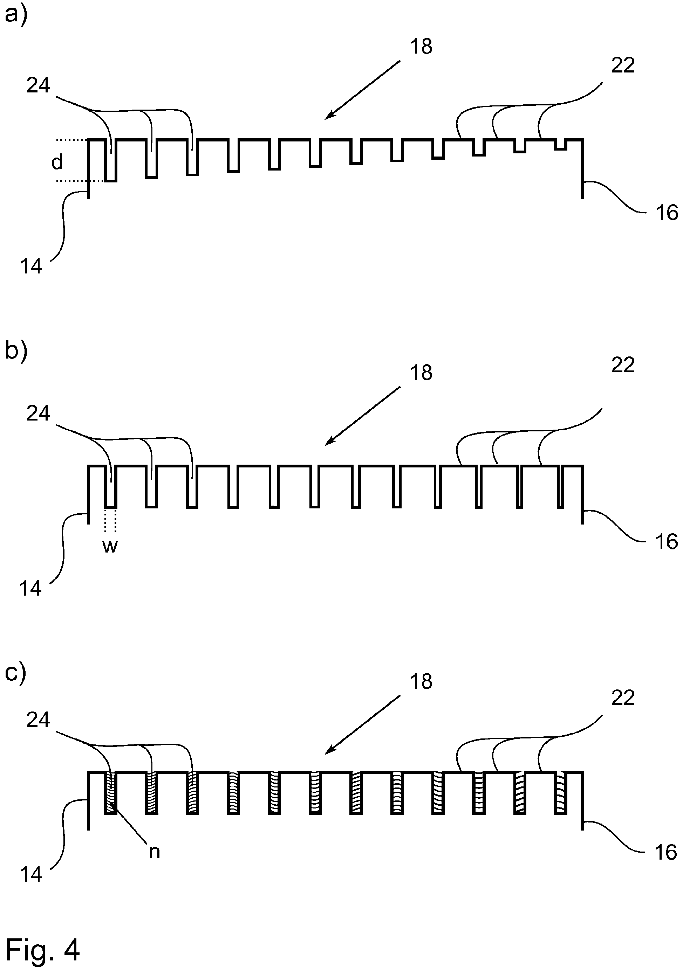

Figur 4 zeigt drei schematische Darstellungen von bevorzugten Ausführungsformen der Gitterstruktur 18 einer erfindungsgemäßen Laserdiode 100 mit verteilter Rückkopplung. Die in Figur 4a gezeigte Darstellung entspricht der Struktur des in der Figur 3 beschriebenen Gitters 18 mit variierender Grabentiefe d bei einer konstanten Grabenbreite w und konstanter Brechzahl n der Gräben 24. Die Zuordnung der einzelnen Bezugszeichen gilt entsprechend. In der Darstellung nach Figur 4b bleiben hingegen die Grabentiefe d und die Brechzahl n der Gräben 24 konstant, während die Breite w der einzelnen Gräben zwischen der Rückfacette 14 und der Frontfacette 16 variiert wird. Insbesondere ist eine Verringerung der Breite der Gräben 24 in Richtung der Frontfacette gezeigt. In der in Figur 4c gezeigten Darstellung ist ein Gitter 18 gezeigt, bei dem sowohl die Tiefe d der einzelnen Gräben 24, als auch die Breite w dieser Gräben 24 konstant gehalten werden. Verändert wird bei dieser Ausführungsform lediglich die Brechzahl n der einzelnen Gräben 24 des Gitters 18. Diese Veränderung kann beispielsweise durch selektives Auffüllen oder teilweises Beschichten von in ein zur Ausbildung eines Gitters 18 geeignetem Material hinein geätzte Gräben 24 oder durch eine Implantation von Fremdatomen in besagtem Material erfolgen. Allen diese Ausführungsformen ist gemein, dass dadurch die Stärke der Wechselwirkung zwischen der im wellenführenden Bereich 12 geführten Welle 26 und dem Gitter 18 entlang der optischen Achse variiert werden kann. Die genannten Ausführungsbeispiele stellen jedoch lediglich einen Teilbereich der insgesamt zur Verfügung stehenden Möglichkeiten einer Beeinflussung dar. Insbesondere kann durch eine geschickte Kombination der genannten Ausführungsformen besonders gezielt die Wechselwirkung beeinflusst werden. Dies gestattet unter anderem, dass bei der Herstellung einer erfindungsgemäßen Laserdiode 100 auf die speziellen Eigenheiten bestimmter Verfahren genau eingegangen werden kann und darüber auch eine weitestgehende Minimierung des störenden Einflusses von Fertigungstoleranzen ermöglicht wird.

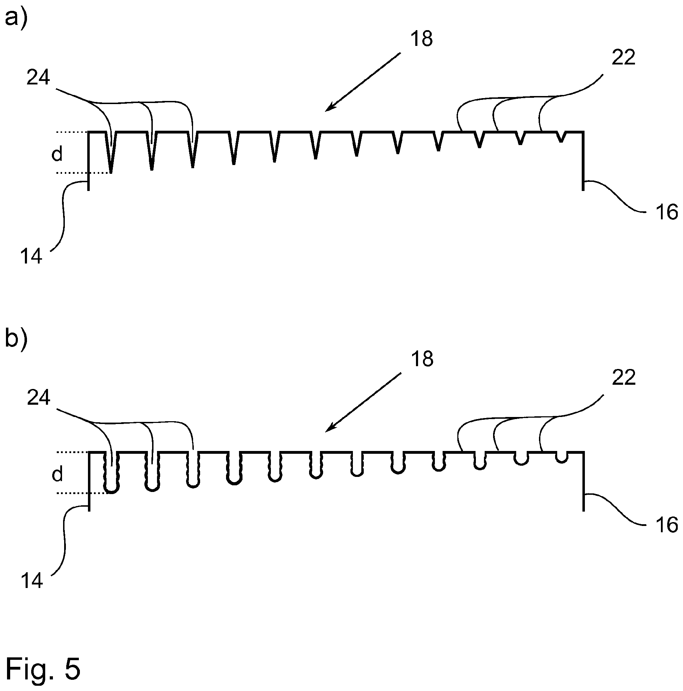

Figur 5 zeigt schematische Darstellungen besonders bevorzugter Ausführungsformen der Gitterstruktur 18 einer erfindungsgemäßen Laserdiode 100 mit verteilter Rückkopplung. Für die Darstellung wurde eine Anordnung der Stege 22 und Gräben 24 des Gitters 18 gewählt, wie sie auch der Abbildung in Figur 4a entspricht, d.h. bei der sich die Tiefe d der Gräben 24 des Gitters 18 ausgehend von der Rückfacette 14 zur Frontfacette 16 hin zunehmend verringert. Im Gegensatz zu den vorgenannten Ausführungsformen und -beispielen haben die einzelnen Gräben 24 hier jedoch eine von der in den bisherigen Figuren stets beispielhaft verwendeten Rechteckform abweichende Wandstruktur. Besonders bevorzugt ist dabei insbesondere die in der Figur 5a dargestellte Gitterstruktur, bei der sich die Breite w der Gräben 24 in Richtung zur aktiven Schicht 10 kontinuierlich V-förmig verjüngt. Durch eine solche Anordnung ist es möglich, die Wechselwirkung zwischen der im wellenführenden Bereich 12 geführten Welle 26 und dem Gitter 18 auch in einer zur aktiven Schicht 10 senkrechten Richtung zu beeinflussen und somit die Kopplung des Gitters 18 auch an die in der Laserdiode 100 entlang dieser Richtung auftretende Leistungsdichteverteilung anzupassen. Insofern stellt diese Ausführungsform eine Variation der Tiefe d der Gräben 24 mit einer überlagerten Variation der Breite w innerhalb der einzelnen Gräben 24 dar. Die in Figur 5b gezeigte Abbildung zeigt ebenfalls eine Variation der Tiefe d der einzelnen Gräben 24 mit einer überlagerten Variation der Breite w innerhalb der einzelnen Gräben 24. Bei diesem Beispiel kann es sich beispielsweise um das Ergebnis eines anisotropen Ätzverfahrens handeln, bei dem die geätzten Wände jedoch keine einheitlich glatte Struktur aufweisen.

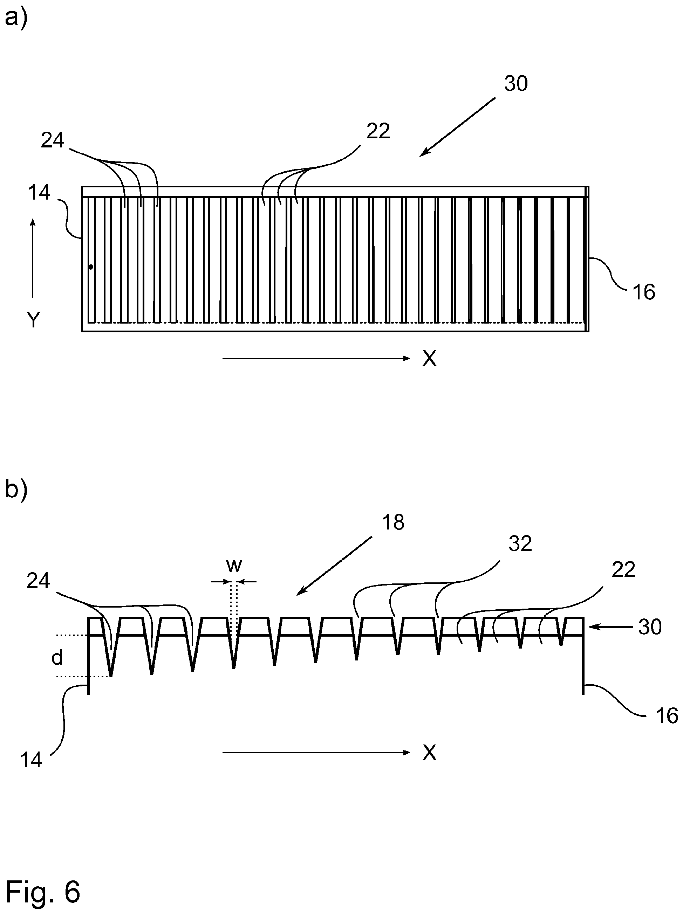

Figur 6 zeigt schematische Darstellungen einer Ätzmaske 30 zur Herstellung einer bevorzugten Ausführungsform einer erfindungsgemäßen Laserdiode 100 mit verteilter Rückkopplung in Aufsicht und im Querschnitt nach dem Ätzen. Die in Figur 6a in Aufsicht dargestellte Ätzmaske 30 kann beispielsweise mittels Kontaktlithographie erzeugt werden. Die Ätzmaske 30 weist unterschiedliche Bereiche mit mehreren Öffnungen 32 auf, durch die die Eigenschaften des erzeugten Gitters 18 festlegt werden. Die dargestellte Ätzmaske 30 ist dazu geeignet, ein Gitter 18 entlang einer ersten Richtung X, welche sich zwischen einer Rückfacette 14 und einer Frontfacette 16 erstreckt, auszubilden, bei dem die Tiefe $d$ der einzelnen Gräben 24 entsprechend einer bevorzugten Ausführungsform nach Figur 3 entlang einer ersten Richtung X zunehmend reduziert wird. Insbesondere wird dies dadurch erreicht, dass erfindungsgemäß auch die Breite der einzelnen Öffnungen 32 der Ätzmaske 30 entlang der ersten Richtung X reduziert wird. Beim reaktiven Ionenätzen kann dadurch der Microloading-Effekt genutzt werden, welcher über eine Variation in der Breite der Öffnungen 32 der Ätzmaske 30 ein Variation der beim Ätzvorgang erzielten Tiefe $d$ der erzeugten Gräben 24 bewirkt. Die Variation der Lacköffnung kann auch über alternative Verfahren wie beispielsweise mittels e-Beam erzeugt werden. Durch ein entsprechendes Design der Maske 30 kann daher eine gezielte Beeinflussung der Breite w und der Tiefe d der erzeugten Gräben 24, sowie den daraus resultierenden $R_{max}(x)$ und $\kappa L(x)$ erfolgen. Dieser Effekt kann zudem durch kombinierte Anwendung einzelner Merkmale der vorgenannten bevorzugten Ausführungsformen einer erfindungsgemäßen Laserdiode 100 mit verteilter Rückkopplung weiter verstärkt bzw. optimiert werden. Die Figur 6b zeigt den Querschnitt einer Ätzmaske 30 zur Herstellung einer bevorzugten Ausführungsform einer erfindungsgemäßen Laserdiode 100 mit verteilter Rückkopplung. Erkennbar sind die erzeugten Stege 22 und Gräben 24 des Gitters 18 sowie die zur Abdeckung während des Ätzvorgangs genutzte Ätzmaske 30 mit ihren Öffnungen 32.

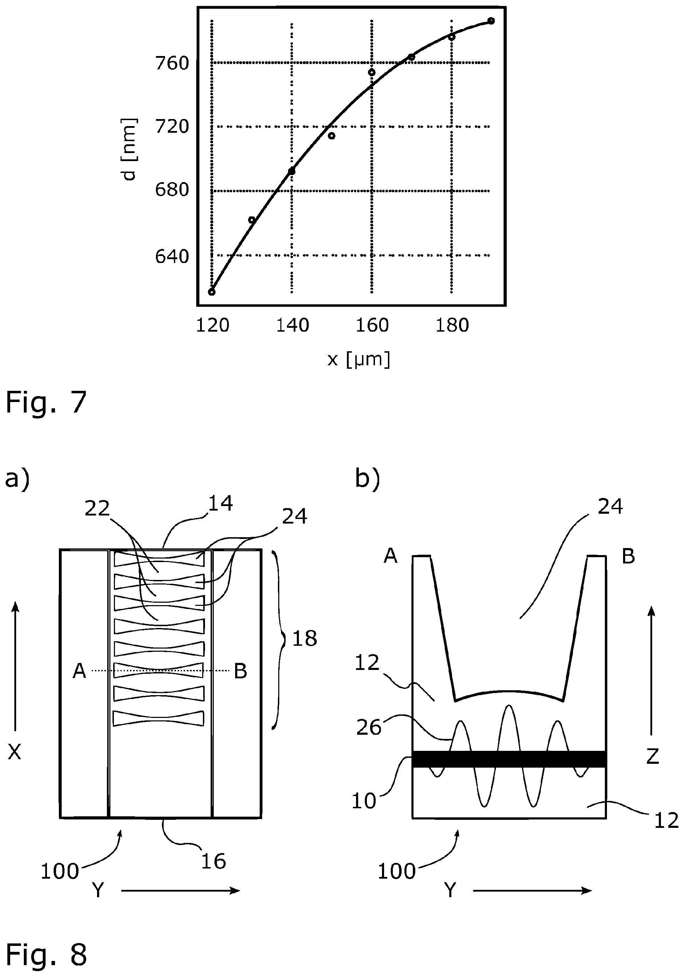

Figur 7 zeigt die experimentell ermittelte Grabentiefe nach der Herstellung einer bevorzugten Ausführungsform einer erfindungsgemäßen Laserdiode 100 mit verteilter Rückkopplung unter Anwendung einer Ätzmaske 30 nach Figur 6. Die Abzisse des dargestellten Diagramms gibt die absolute Position eines Grabens 24 entlang der longitudinalen ersten Richtung X an, wobei der Abstand zwischen den einzelnen Gräben 24 jeweils 10 μm beträgt. Die Ordinate des Diagramms entspricht der gemessenen Grabentiefe $d$ des jeweiligen Grabens 24. Durch die unterschiedliche Breite der Öffnungen 32 der Ätzmaske 30 kommt es beim anisotropen reaktivem Ionenätzen zum Microloading-Effekt, welcher erfindungsgemäß zu der gewünschten Variation bei der gemessenen Grabentiefe $d$ führt. Die experimentell bestimmten Tiefen d der Gräben 24 sind als einzelne Kreise dargestellt. Die durchgezogene Line entspricht einem gemittelten Verlauf der erzielten Tiefenmodulation. Hierbei entspricht eine größere Grabentiefe d einer breiteren Öffnung 32 in der Ätzmaske 30. Einer kleineren Grabentiefe $d$ kann hingegen eine schmalere Öffnung 32 in der Ätzmaske 30 zugeordnet werden. Der zur Herstellung der Laserdiode 100 mit verteilter Rückkopplung erfindungsgemäß genutzte Microloading-Effekt kann im Bezug auf die weiteren Gitterparameter sehr genau vorausberechnet werden, so dass über die Ätzmaske 30 bei einer erfindungsgemäßen Laserdiode 100 mit verteilter Rückkopplung eine genaue Einstellung der Stärke der Wechselwirkung zwischen der im wellenführenden Bereich 12 geführten Welle 26 und dem erzeugten Gitter 18 erfolgen kann.

Figur 8 zeigt schematische Darstellungen einer weiteren bevorzugten Ausführungsform einer erfindungsgemäßen Laserdiode 100 mit verteilter Rückkopplung in Aufsicht und im Querschnitt. Die Figur 8a stellt eine Aufsicht auf das Gitter 18 einer erfindungsgemäßen Laserdiode 100 mit verteilter Rückkopplung dar. Diese Aufsicht erstreckt sich entlang einer ersten Richtung X und einer zweiten Richtung Y, wobei jeweils die Rückfacette 14 und die Frontfacette 16 angeschnitten sind. Zwischen diese beiden Facetten erstreckt sich teilweise das Gitter 18 entlang der ersten Richtung X. Entsprechend der vorhergehenden Ausführungsbeispiele weist dieses Gitter mehrere Stege 22 und Gräben 24 auf, wobei sich die Breite w dieser Gräben 24 sowohl in der ersten Richtung X als auch in der zweiten Richtung Y unterscheiden kann. Hierdurch wird eine Variation der Wechselwirkung zwischen der im wellenführenden Bereich 12 geführten Welle 26 und dem Gitter 18 auch entlang der zweiten Richtung Y ermöglicht, so dass auch in diese Richtung eine erfindungsgemäße Anpassung der Kopplungsstärke des Gitters 18 an die lokale Leistungsdichteverteilung innerhalb der Laserdiode 100 mit verteilter Rückkopplung erreicht werden kann. Die durch den Microloading-Effekt beim reaktiven Ionenätzen erzeugte Variation der Tiefe $d$ der einzelnen Gräben entlang der in Figur 6a eingezeichneten Line A-B kann der Figur 6b entnommen werden. Analog zur vorhergehenden Beschreibung ist die Tiefe d der Gräben 24 im Bereich geringer Grabenbreite w herabgesetzt, während in den Bereichen hoher Grabenbreite w auch eine höhere Grabentiefe d erreicht wird. Daraus resultiert eine entsprechend höheres $R_{max}(x)$ und $\kappa L(x)$. Durch eine entsprechende Kombination mit einem in Figur 5a gezeigtem V-förmigen Ätzprofil lässt sich somit in allen drei Raumrichtungen eine Anpassung der Kopplungsstärke des Gitters 18 an die im wellenführenden Bereich 12 geführte Welle 26 erreichen.

Die Umsetzung der erfinderischen Idee wurde in Messreihen erfolgreich demonstriert. Insbesondere wurden erfindungsgemäße Breitstreifen-Laserdioden mit verteilter Rückkopplung bei entlang der optischen Achse variierender Kopplungsstärke durch entsprechende Anpassung des Kopplungsparameters an die Leistungsdichte innerhalb der Laserdiode hergestellt. Neben Laserdioden mit Gitterstrukturen konstanter Grabentiefe nach dem Stand der Technik wurden auch Laserdioden mit Gitter einer zur Frontfacette hin abnehmenden Grabentiefe prozessiert. Die Laserdioden wurden anschließend auf der Rückfacette mit einem Reflexionsgrad $R_R$ = 95% und auf der Frontfacette mit einem Reflexionsgrad $R_F$ < 0.05% beschichtet. Für die Laserdioden konnten Leistungskennlinien im Dauerstrichbetrieb bei Stromstärken bis 2 A aufgenommen werden. Darüber hinaus wurde die spektrale Emission bei Temperaturen von -20°C bis 50°C in 5°C-Schritten gemessen, um den thermischen Locking-Bereich $\Delta T$ zu bestimmen. Dieser gibt an, über welchen Temperaturbereich die Emission longitudinal einzelmodig bleibt ohne das andere Bragg- oder Fabry-Pérot-Moden anschwingen.

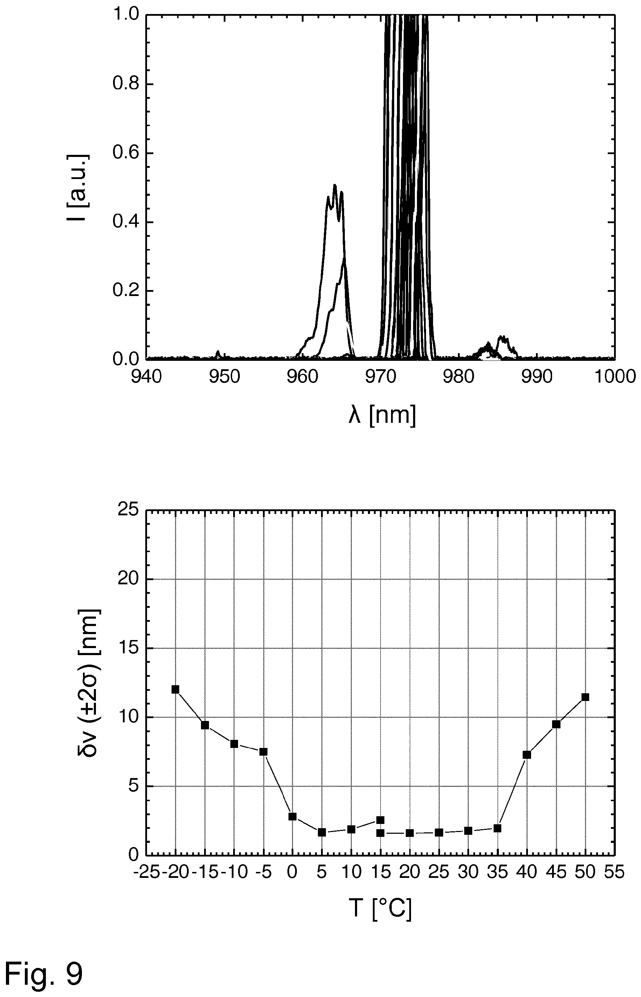

Figur 9 zeigt eine exemplarische Leistungskurve einer herkömmlichen Laserdiode mit verteilter Rückkopplung durch ein uniformes Gitter (Crump et al., J. Phys. D: Appl. Phys. 46 (2013) 013001). Die Laserdiode emittiert Strahlung bevorzugt im Wellenlängenbereich um 973 nm und kann durch thermische Abstimmung im Wesentlichen über einen Bereich von 6 nm zwischen 970 nm und 976 nm zu einer schmalbandigen Emission bei typischen Linienbreiten unterhalb von 1 nm ($\pm 2\sigma$) angeregt werden. Der Locking-Bereich $\Delta T$ der Laserdiode beträgt 35 K. Die Wellenlänge schiebt thermisch mit etwa 0.08 nm/K. Der dabei bei einer Arbeitstemperatur $T$ von etwa 20 C gemessene elektro-optische Leistungsanstieg lag bei $S$ = 0.9 W/A.

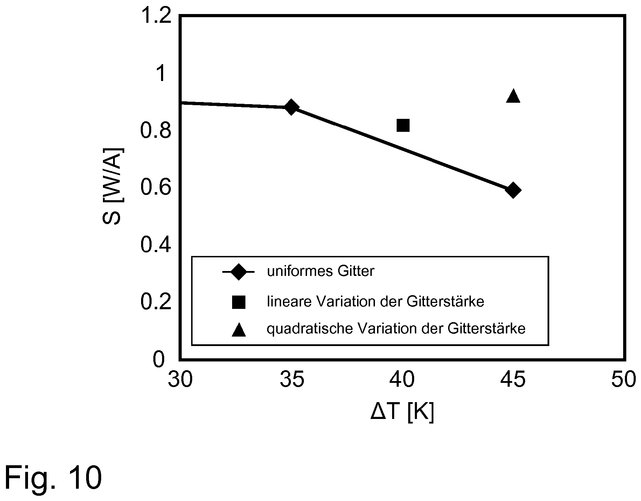

Figur 10 zeigt das Leistungsverhalten bevorzugter Ausführungsformen erfindungsgemäßer Laserdioden 100 mit verteilter Rückkopplung im Vergleich zu einer herkömmlichen Laserdiode mit verteilter Rückkopplung durch ein uniformes Gitter. Hierbei sind die jeweils maximal gemessenen elektro-optischen Leistungsanstiege $S$ über der Temperatur $T$ im Locking-Bereich $\Delta T$ der Laserdiode aufgetragen. Bei dem hier gezeigten herkömmlichen Gitter konnte im Gegensatz zu der in Figur 9 gezeigten Leistungskurve durch Änderung der Gitterparameter der Locking-Bereich $\Delta T$ der Laserdiode auf 45 K erweitert werden. Wie der entsprechenden Kurve jedoch zu entnehmen ist, fällt in diesem Bereich der elektro-optische Leistungsanstieg $S$ mit Werten unter 0.6 W/A deutlich ab, so dass hier im Allgemeinen bei Hochleistungslaserdioden auch mit einer abfallenden Ausgangsleitung in diesem Spektralbereich gerechnet werden muss. Bei einer erfindungsgemäßen Laserdiode mit einer lineareren Variation der Gitterstärke $R_{max}(x)$ und $\kappa L(x)$ wurde einen Locking-Bereich $\Delta T$ von 40 K gemessen. Der elektro-optischen Leistungsanstieg S blieb dabei auch in diesem Bereich bei einem Wert von über 0.8 W/A. Bei einer quadratischen Variation der Gitterstärke konnte ein Locking-Bereich $\Delta T$ von 45 K bei einem elektro-optischen Leistungsanstieg $S$ von etwa 0.9 W/A gemessen werden.

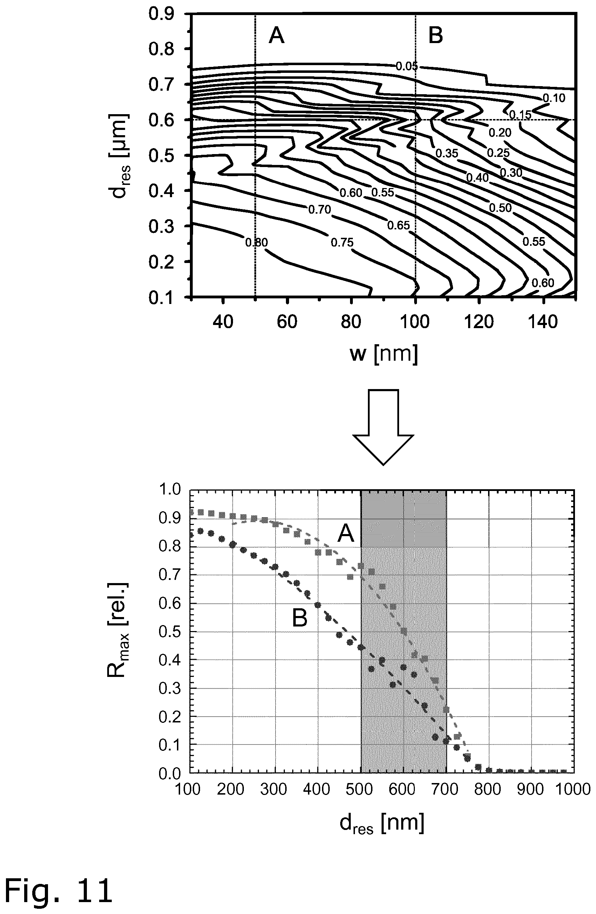

Figur 11 zeigt eine numerische Simulation zur Bestimmung des maximal erreichbaren Reflexionsgrades $R_{max}$ ($d_{res}$, w) einer Gitterstruktur in Abhängigkeit vom Abstand $d_{res}$ der Gräben zur aktiven Schicht und der minimalen Breite w der Gräben in der Nähe zur aktiven Schicht bei einem uniformen Gitter. Die maximal erreichbaren Reflexionsgrade $R_{max}$ sind als Isolininenplan dargestellt. Aus diesem kann der spezifische Verlauf der Isolinien einzelner Reflexionswerte entnommen werden. Die beiden gestrichelt eingezeichneten Senkrechten entsprechen dabei Werten für eine typische minimalen Breite w der Gräben von 50 nm bzw. 100 nm. Der Einfluss der Brechzahl $n$ der Gräben wurde hierbei nicht explizit mit betrachtet und daher wird diese als konstant für alle Gräben angenommen. Bei der Berechnung wurde ein Oberflächengitter der Ordnung $N$ = 40 mit einer Gesamtlänge $L$ = 6 mm zugrunde gelegt. Aus den Schnitten der Senkrechten mit den einzelnen Isolininen lässt sich der Verlauf des maximal erreichbaren Reflexionsgrades $R_{max}$ in Abhängigkeit vom Abstand $d_{res}$ der Gräben zur aktiven Schicht bei entsprechender fester Breite $w$ der Gräben entnehmen. Dieser Verlauf ist im unteren Teil der Figur 11 dargestellt. In den gezeigten Beispielen ergibt sich im Bereich zwischen 500 nm und 700 nm eine nahezu lineare Abhängigkeit zwischen dem Abstandes $d_{res}$ der Gräben zur aktiven Schicht und dem dabei maximal erreichbaren Reflexionsgrad $R_{max}$. Diese beiden Grenzwerte definieren einen bevorzugten Arbeitsbereich bei der Herstellung einer solchen erfindungsgemäßen Laserdiode, da durch den einfachen funktionellen Zusammenhang Toleranzen bei der Herstellung nur schwach ins Gewicht fallen und somit in diesem Bereiches eine besonders einfache und zuverlässige Einstellung eines gewünschten Reflexionsgrades bei der Herstellung des Gitters erfolgen kann.

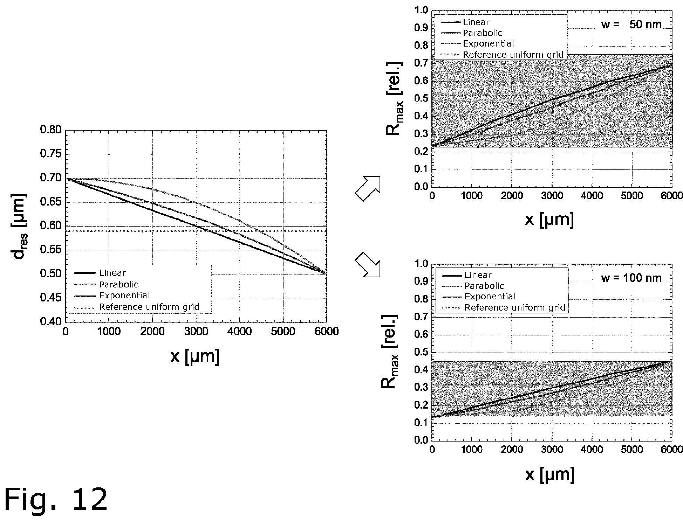

Figur 12 zeigt eine numerische Simulation zur Bestimmung des örtlich aufgelösten maximalen Reflexionsgrades $R_{max}(x)$ des Gitters für mehrere Ausführungsformen einer Laserdiode mit einer erfindungsgemäßen Variation der effektiven Gitterstärke. Die Länge $L$ der hergestellten Gitteranordnungen betrug dabei jeweils 6 mm. Dargestellt sind insbesondere der ortsaufgelöste Verlauf des Abstandes $d$ der Gräben zur aktiven Schicht in Abhängigkeit von der Gitterposition $x$ für drei verschiedene Gittertypen mit linearer, parabolischer und exponentieller Abhängigkeit des Reflexionsgrades von der Gitterposition $x$. Weiterhin ist der Verlauf des örtlich aufgelösten maximalen Reflexionsgrades $R_{max}(x)$ für ein konventionelles uniformes Gitter mit einem festen Reflexionsgrad über die gesamte Länge $L$ des Gitters als Referenz dargestellt. Die Variation des Abstand $d$ der Gräben zur aktiven Schicht erfolgt hier bevorzugt in dem aus Figur 11 für diesen Parameter bestimmten linearen Arbeitsbereich zwischen 500 nm und 700 nm. Aus der gezeigten Parametervariation kann die Abhängigkeit des örtlich aufgelösten Reflexionsgrades $R_{max}(x)$ in Abhängigkeit von der Gitterposition $x$ mit Hilfe der ebenfalls in Figur 11 gezeigten Kurvenverläufe ermittelt werden. Daraus lässt sich insbesondere entnehmen, dass für Gräben mit einer festen minimalen Breite $w$ von 50 $\mu$m im linearen Arbeitsbereich der örtlich aufgelösten maximalen Reflexionsgrades $R_{max}(x)$ zwischen Rück- und Frontfacette der Laserdiode zwischen etwa 0.2 und 0.7 variiert, während für Gräben mit einer festen minimalen Breite $w$ von 100 $\mu$m unter annähernd gleichen Bedingungen der örtlich aufgelösten maximalen Reflexionsgrades $R_{max}(x)$ zwischen Rück- und Frontfacette lediglich Werte zwischen 0.1 und 0.5 variiert. Wenn beim Design einer erfindungsgemäßen Laserdioden nur einer der möglichen Gitterparameter variiert werden soll, so sollten darüber hinaus auch alle weiteren Parameter auf ihren Einfluss hin

**EP 3 317 931 B1**

untersucht und entsprechend berücksichtigt werden. Aus den Verläufen für die einzelnen Reflexionsgrade $R_{max}(x)$ kann eine Apodisierungsmaßzahl A für das Gitter bestimmt werden. Für die untersuchten Gitter ergeben sich aus Figur 12 Werte um 3.5 bzw. 5, welche allesamt größer als 1.1 sind. Die Werte für das Koppelfaktor-Länge-Produkt $\kappa L(x)$ ergeben sich mit den gezeigten Kurvenverläufen durch Umrechnung in entsprechender Weise.

Diese Ergebnisse zeigen, dass durch eine erfindungsgemäße Variation und Anpassung der Kopplungsstärke des Gitters an die optische Leistungsdichte innerhalb der Laserdiode eine deutliche Verbesserung der Leistungsparameter erzielt werden kann. Im vorliegenden Fall konnte durch eine Apodisierung des Gitters eine Erhöhung der thermischen Stabilität und des thermischen Abstimmverhaltens der Laserdiode zwischen 5 K und 10 K, im Gegensatz zu einer herkömmlichen Laserdiode mit verteilter Rückkopplung durch ein uniformes Gitter, ohne eine wesentliche Verschlechterung des elektro-optischen Leistungsanstiegs S demonstriert werden.

Insbesondere konnten Laserdioden demonstriert werden, bei denen eine erfindungsgemäße Variation $V_{dres}$ im Abstand $d_{res}$ der einzelnen Gräben zur aktiven Schicht eingestellt werden konnte. Hierbei lagen das globale Maximum des Abstandes $d_{res}$ bei 0.50 μm und das globale Minimum des Abstandes $d_{res}$ bei 0.70 μm. Damit lag die bevorzugte Variation $V_{dres}$ im Abstand $d_{res}$ der einzelnen Gräben zur aktiven Schicht bei 1.4. Die beiden Extremwerte lagen hier jeweils an einer der Außenfacetten der Laserdiode vor.

Es sei abschließend noch darauf hingewiesen, dass es sich bei den gezeigten Ergebnissen zu den erfindungsgemäßen Laserdioden um vorläufige erste Testmessungen an einzelnen Prototypen handelt. Insbesondere erfolgten hierbei noch keine umfassenden Prozess- und Parameteroptimierungen, so dass durchaus die Möglichkeit zu einer erheblichen weiteren Ausdehnung des möglichen Locking-Bereichs besteht.

**Bezugszeichenliste**

| | |
|---|---|
| 10 | aktive Schicht |
| 12 | wellenführender Bereich |
| 14 | Rückfacette |
| 16 | Frontfacette |
| 18 | Gitter |
| 22 | Stege |
| 24 | Gräben |
| 26 | geführte Welle |
| 28 | Leistungsdichte |
| 30 | Ätzmaske |
| 32 | Maskenöffnungen |
| 100 | Laserdiode |
| $d$ | Grabentiefe |
| $d_{res}$ | Abstand des Grabens zur aktiven Schicht |
| $w$ | Grabenbreite |
| $n$ | Brechzahl (auch Brechungsindex) |
| $\Delta n$ | Brechzahlunterschied (auch Brechungsindexkontrast) |
| $\Lambda$ | Gitterkonstante |
| $I$ | Intensität |
| $\Delta\lambda$ | spektrale Linienbreite |
| $\Delta\lambda_{det}$ | Detuning |
| S | elektro-optischer Leistungsanstieg |
| $R$ | Reflexionsgrad |
| $\kappa L$ | Koppelfaktor-Länge-Produkt |
| X | erste Achse oder Richtung |
| Y | zweite Achse oder Richtung |
| $P$ | Kopplungsparameter |
| $A$ | Apodisierungsmaßzahl |
| $V$ | Variation |

**Patentansprüche**

**1.** Laserdiode (100) umfassend:

eine aktive Schicht (10);

einen die aktive Schicht (10) zumindest teilweise umgebenden wellenführenden Bereich (12);

eine Rückfacette (14);

eine zur Auskopplung von Laserstrahlung ausgelegte Frontfacette (16), wobei sich die aktive Schicht (10) zumindest teilweise entlang einer ersten Achse (X) zwischen der Rückfacette (14) und der Frontfacette (16) erstreckt; und

ein Gitter (18), das mit dem wellenführenden Bereich (12) wirkverbunden ist, wobei das Gitter (18) eine Vielzahl von Stegen (22) und Gräben (24) umfasst; und

die Vielzahl der Gräben (24) derart ausgebildet ist, dass ein mittlerer Anstieg eines Kopplungsparameters $P$ für die Vielzahl der Gräben (24) entlang des Gitters (18) ungleich Null ist, wobei der Kopplungsparameter $P$ eines Grabens (24) durch die Formel (1)

$$P = \frac{\Delta n}{w d_{res}} \qquad (1)$$

definiert ist, wobei $d_{res}$ ein minimaler Abstand zwischen einer der aktiven Schicht zugewandten Seite des Grabens (24) und einer dem Graben (24) zugewandten Seite der aktiven Schicht (10), $w$ eine Breite des Grabens (24) und $\Delta n$ ein Brechzahlunterschied zwischen einer Brechzahl des Grabens (24) und einer Brechzahl eines den Graben (24) umgebenden Materials ist;

**dadurch gekennzeichnet, dass**

es sich bei dem Gitter (18) um ein Oberflächengitter handelt und die Ordnung des Gitters (18) im Bereich zwischen 10 und 100 liegt.

2. Laserdiode (100) nach Anspruch 1, wobei das Gitter (18) eine auf den Kopplungsparameter P bezogene Apodisierungsmaßzahl $A_P$ von größer oder gleich 1.1 aufweist, wobei sich die Apodisierungsmaßzahl $A_P$ gemäß Formel (2)

$$A_P = \frac{Maximum\{P\}}{Minimum\{P\}} \qquad (2)$$

aus dem Verhältnis zwischen einem maximalen und einem minimalen Wert für den Kopplungsparameter $P$ der Vielzahl von Gräben (24) des Gitters (18) ergibt.

3. Laserdiode (100) nach Anspruch 1, wobei das Gitter (18) eine auf den lokalen Reflexionsgrad $R(x)$ bezogene Apodisierungsmaßzahl $A_R$ von größer oder gleich 1.1 aufweist, wobei sich die Apodisierungsmaßzahl $A_R$ gemäß Formel (3)

$$A_R = \frac{Maximum\{R(x)\}}{Minimum\{R(x)\}} \qquad (3)$$

aus dem Verhältnis zwischen einem maximalen und einem minimalen Wert für den lokalen Reflexionsgrad $R(x)$ des Gitters (18) ergibt.

4. Laserdiode (100) nach Anspruch 1, wobei das Gitter eine auf das lokale Koppelfaktor-Länge-Produkt $\kappa L$ bezogene Apodisierungsmaßzahl $A_{\kappa L}$ von größer oder gleich 1.1 aufweist, wobei sich die Apodisierungsmaßzahl $A_{\kappa L}$ gemäß Formel (4)

$$A_{\kappa L} = \frac{Maximum\{\kappa L(x)\}}{Minimum\{\kappa L(x)\}} \qquad (4)$$

aus dem Verhältnis zwischen einem maximalen und einem minimalen Wert für das lokale Koppelfaktor-Länge-Produkt $\kappa L(x)$ des Gitters (18) ergibt.

5. Laserdiode (100) nach Anspruch 3 oder 4, wobei sich die Gitterstärke entlang der longitudinalen Achse quadratisch erhöht und die Apodisierungsmaßzahl *A* größer oder gleich 3 ist.

6. Laserdiode (100) nach einem der vorhergehenden Ansprüche, wobei der Kopplungsparameter *P* der einzelnen Gräben (24) an die Leistungsdichte der im wellenführenden Bereich (12) geführten Welle (26) angepasst ist, wobei in den Bereichen hoher Leistungsdichte der Kopplungsparameter *P* herabgesetzt ist gegenüber dem Kopplungsparameter *P* in den Bereichen niedriger Leistungsdichte.

7. Laserdiode (100) nach einem der vorhergehenden Ansprüche, wobei eine Variation $V_{dres}$ im Abstand $d_{res}$ der einzelnen Gräben (24) zur aktiven Schicht (10) größer oder gleich 1.1 ist.

8. Laserdiode (100) nach einem der vorhergehenden Ansprüche, wobei eine Variation $V_{\Delta n}$, im Brechzahlunterschied $\Delta n$ zwischen der jeweiligen Brechzahl eines einzelnen Grabens (24) und der Brechzahl des den Graben (24) umschließenden Materials größer oder gleich 1.1 ist.

9. Laserdiode (100) nach einem der vorangegangenen Ansprüche, wobei die Länge *L* des Gitters (24) größer oder gleich 100 μm ist oder mindestens 10 % des Abstandes zwischen der Rückfacette (14) und der Frontfacette (16) entlang der ersten Achse (X) entspricht.

10. Laserdiode (100) nach einem der vorangegangenen Ansprüche, wobei sich das Gitter über die komplette Resonatorlänge erstreckt oder in mindestens zwei Teilgitter aufgeteilt ist, wobei die mindestens zwei Teilgitter zwischen der Rückfacette (14) und der Frontfacette (16) entlang der ersten Achse (X) arbiträr verteilt sind.

11. Laserdiode (100) nach Anspruch 10, wobei sich die Gräben (24) des Gitters (18) vollständig oder teilweise in Bereichen mit optischen Gewinn oder ohne optischen Gewinn befinden.

12. Laserdiode (100) nach einem der vorhergehenden Ansprüche, wobei die Vielzahl der Gräben (24) äquidistant beabstandet ist, wobei sich bei mindestens einem der Gräben (24) eine Breite *w* des Grabens (24) in Richtung zur aktiven Schicht (10) hin verjüngt und/oder wobei die Wände der Gräben (24) unterschiedliche Profile aufweisen.

13. Laserdiode (100) nach einem der vorhergehenden Ansprüche, wobei der Kopplungsparameter *P* der einzelnen Gräben (24) entlang einer zweiten Achse (Y), die sich senkrecht zur ersten Achse (X) erstreckt, ortsabhängig ist und der ortsabhängige Kopplungsparameter *P* eines Grabens (24) an die Leistungsdichte der im wellenführenden Bereich (12) geführten Welle (26) angepasst ist, wobei in den Bereichen hoher Leistungsdichte der Wert des ortsabhängigen Kopplungsparameters *P* des Grabens (24) herabgesetzt ist gegenüber dem Wert des ortsabhängigen Kopplungsparameters *P* des Grabens (24) in den Bereichen niedriger Leistungsdichte.

14. Verfahren zur Herstellung einer Laserdiode (100) umfassend:

   - Bereitstellen einer aktiven Schicht (10) und eines die aktive Schicht (10) zumindest teilweise umgebenden wellenführenden Bereichs (12);
   - Ausbilden einer Rückfacette (14) und einer zur Auskopplung von Laserstrahlung ausgelegte Frontfacette (16), wobei sich die aktive Schicht (10) zumindest teilweise entlang einer ersten Achse (X) zwischen der Rückfacette (14) und der Frontfacette (16) erstreckt; und
   - Ausbilden eines Gitters (18) mit einer Vielzahl von Stegen (22) und Gräben (24) derart, dass das Gitter (18) mit dem wellenführenden Bereich (12) wirkverbunden ist,

   wobei es sich um ein Oberflächengitter handelt und die Ordnung des Gitters im Bereich zwischen 10 und 100 liegt, und
   wobei die Vielzahl der Gräben (24) derart ausgebildet wird, dass ein mittlerer Anstieg eines Kopplungsparameters *P* für die Vielzahl der Gräben (24) entlang des Gitters (18) ungleich Null ist, wobei der Kopplungsparameter *P* eines Grabens (24) durch die Formel (5)

$$P = \frac{\Delta n}{w d_{res}} \qquad (5)$$

   definiert ist, wobei $d_{res}$ ein minimaler Abstand zwischen einer der aktiven Schicht zugewandten Seite des Grabens (24) und einer dem Graben (24) zugewandten Seite der aktiven Schicht (10), *w* eine Breite des Grabens (24) und Δ*n* ein Brechzahlunterschied zwischen einer Brechzahl des Grabens (24) und einer Brechzahl eines den Graben (24) umgebenden Materials ist.

15. Verfahren zur Herstellung einer Laserdiode (100) nach Anspruch 14, weiterhin umfassend:

Aufbringen einer Ätzmaske (30) mit einer Vielzahl von Öffnungen (32), auf den wellenführenden Bereich (12), wobei die Breite der Öffnungen (32) entlang einer ersten Achse (X) und/oder einer zweiten Achse (Y) örtlich variiert; und
Strukturieren des maskierten wellenführenden Bereichs (12) durch ein Ätzverfahren.

**Claims**

1. A laser diode (100) comprising:

an active layer (10);
a wave-guiding region (12) at least partially surrounding the active layer (10);
a back facet (14);
a front facet (16) which is designed to decouple laser radiation, the active layer (10) extending at least in part along a first axis (X) between the back facet (14) and the front facet (16); and
a grating (18) which is operatively connected to the wave-guiding region (12), the grating (18) having a plurality of ribs (22) and grooves (24),
and
the plurality of grooves (24) being designed such that an average increase in a coupling parameter $P$ for the plurality of grooves (24) along the grating (18) is not equal to zero, the coupling parameter $P$ of a groove (24) being defined by formula (1)

$$P = \frac{\Delta n}{w\, d_{res}} \qquad (1)$$

in which $d_{res}$ is a minimum distance between a side of the groove (24) facing the active layer and a side of the active layer (10) facing the groove (24), $w$ is a width of the groove (24), and $\Delta n$ is a difference in refractive index between a refractive index of the groove (24) and a refractive index of a material surrounding the groove (24),
**characterized in that**
the grating (18) is a surface grating, and the order of the grating (18) is in the range of between 10 and 100.

2. The laser diode (100) according to Claim 1, wherein the grating (18) has an apodization numerical value $A_P$, relating to the coupling parameter $P$, of greater than or equal to 1.1, the apodization numerical value $A_P$ being found according to formula (2)

$$A_P = \frac{Maximum\{P\}}{Minimum\{P\}} \quad A_P = \frac{Maximum\{P\}}{Minimum\{P\}} \qquad (2)$$

from the relationship between a maximum value and a minimum value for the coupling parameter $P$ of the plurality of grooves (24) of the grating (18).

3. The laser diode (100) according to Claim 1, wherein the grating (18) has an apodization numerical value $A_R$, relating to the local reflectance $R(x)$, of greater than or equal to 1.1, the apodization numerical value $A_R$ being found according to formula (3)

$$A_R = \frac{Maximum\{R(x)\}}{Minimum\{R(x)\}} \qquad (3)$$

from the relationship between a maximum value and a minimum value for the local reflectance $R(x)$ of the grating (18).

4.  The laser diode (100) according to Claim 1, wherein the grating has an apodization numerical value $A_{\kappa L}$, relating to the local coupling coefficient-length product $\kappa L$, of greater than or equal to 1.1, the apodization numerical value $A_{\kappa L}$ being found according to formula (4)

$$A_{\kappa L} = \frac{Maximum\{\kappa L(x)\}}{Minimum\{\kappa L(x)\}} \qquad (4)$$

from the relationship between a maximum value and a minimum value for the local coupling coefficient-length product $\kappa L(x)$ of the grating (18).

5.  The laser diode (100) according to Claim 3 or 4, wherein the grating strength quadratically increases along the longitudinal axis, and the apodization numerical value A is greater than or equal to 3.

6.  The laser diode (100) according to any one of the preceding claims, wherein the coupling parameter $P$ of the individual grooves (24) is adapted to the power density of the wave (26) guided in the wave-guiding region (12), the coupling parameter $P$ being reduced in the regions of higher power density in relation to the coupling parameter $P$ in the regions of lower power density.

7.  The laser diode (100) according to any one of the preceding claims, wherein a variation $V_{dres}$ in the spacing $d_{res}$ of the individual grooves (24) from the active layer (10) is greater than or equal to 1.1.

8.  The laser diode (100) according to any one of the preceding claims, wherein a variation $V_{\Delta n}$ in the difference $\Delta n$ in refractive index between the refractive index of a particular individual groove (24) and the refractive index of the material surrounding the groove (24) is greater than or equal to 1.1.

9.  The laser diode (100) according to any one of the preceding claims, wherein the length $L$ of the grating (24) is greater than or equal to 100 $\mu$m or corresponds to at least 10% of the distance between the back facet (14) and the front facet (16) along the first axis (X).

10. The laser diode (100) according to any one of the preceding claims, wherein the grating extends over the entire resonator length or is divided into at least two sub-gratings, the at least two sub-gratings being arbitrarily distributed along the first axis (X) between the back facet (14) and the front facet (16).

11. The laser diode (100) according to Claim 10, wherein the grooves (24) of the grating (18) are located entirely or partially in regions having optical gain or without optical gain.

12. The laser diode (100) according to any one of the preceding claims, wherein the plurality of grooves (24) are equidistant from one another, wherein a width w of the groove (24) tapers towards the active layer (10) for at least one of the grooves (24), and/or the walls of the grooves (24) have different profiles.

13. The laser diode (100) according to any one of the preceding claims, wherein the coupling parameter P of the individual grooves (24) is dependent on the location along a second axis (Y) extending perpendicular to the first axis (X), and the location-dependent coupling parameter $P$ of a groove (24) is adapted to the power density of the wave (26) guided in the wave-guiding region (12), the value of the location-dependent coupling parameter $P$ of the groove (24) being reduced in the regions of higher power density in relation to the location-dependent coupling parameter $P$ of the groove (24) in the regions of lower power density.

14. A method for producing a laser diode (100), comprising:

    - providing an active layer (10) and a wave-guiding region (12) which at least partially surrounds the active layer (10);
    - forming a back facet (14) and a front facet (16) which is designed to decouple laser radiation, the active layer (10) extending at least in part along a first axis (X) between the back facet (14) and the front facet (16); and
    - forming a grating (18) having a plurality of ribs (22) and grooves (24), in such a way that the grating (18) is operatively connected to the wave-guiding region (12),

      wherein the grating is a surface grating, and the order of the grating is in the range of between 10 and 100, and

wherein the plurality of grooves (24) are designed such that an average increase in a coupling parameter $P$ for the plurality of grooves (24) along the grating (18) is not equal to zero, the coupling parameter $P$ of a groove (24) being defined by formula (5)

$$P = \frac{\Delta n}{w\, d_{res}} \qquad\qquad (5)$$

in which $d_{res}$ is a minimum distance between a side of the groove (24) facing the active layer and a side of the active layer (10) facing the groove (24), $w$ is a width of the groove (24), and $\Delta n$ is a difference in refractive index between a refractive index of the groove (24) and a refractive index of a material surrounding the groove (24).

15. The method for producing a laser diode (100) according to Claim 14, further comprising:

applying an etching mask (30) having a plurality of openings (32) onto the wave-guiding region (12), the width of the openings (32) varying by location along a first axis (X) and/or a second axis (Y); and
structuring the masked wave-guiding region (12) by means of an etching process.

**Revendications**

1. Diode laser (100) comprenant :

une couche active (10) ;
une zone de guidage d'ondes (12) entourant au moins en partie la couche active (10) ;
une facette arrière (14) ;
une facette avant (16) conçue pour la sortie du rayonnement laser, la couche active (10) s'étendant au moins en partie le long d'un premier axe (X) entre la facette arrière (14) et la facette avant (16) ; et
un réseau (18), qui est en liaison fonctionnelle avec la zone de guidage d'ondes (12), le réseau (18) comprenant une pluralité de nervures (22) et de tranchées (24) ;
et
la pluralité des tranchées (24) est réalisée de telle manière qu'une augmentation moyenne d'un paramètre de couplage $P$ pour la pluralité de tranchées (24) le long du réseau (18) est différente de zéro, le paramètre de couplage P d'une tranchée (24) étant défini par la formule (1)

$$P = \frac{\Delta n}{w d_{res}} \qquad\qquad (1),$$

où $d_{res}$ est une distance minimale entre un côté de la tranchée (24) orienté vers la couche active et un côté de la couche active (10) orienté vers la tranchée (24), $w$ est une largeur de la tranchée (24) et $\Delta n$ est une différence d'indice de réfraction entre un indice de réfraction de la tranchée (24) et un indice de réfraction d'un matériau entourant la tranchée (24) ;
**caractérisée en ce que**
le réseau (18) est un réseau de surface et l'ordre du réseau (18) se trouve dans la plage comprise entre 10 et 100.

2. Diode laser (100) selon la revendication 1, dans laquelle le réseau (18) présente un coefficient d'apodisation $A_P$ par rapport au paramètre de couplage P supérieur ou égal à 1,1, le coefficient d'apodisation $A_P$ résultant, selon la formule (2)

$$A_P = \frac{Maximum\{P'\}}{Minimum\{P\}} \qquad\qquad (2),$$

du rapport entre une valeur maximale et une valeur minimale pour le paramètre de couplage $P$ de la pluralité de tranchées (24) du réseau (18).

**3.** Diode laser (100) selon la revendication 1, dans laquelle le réseau (18) présente un coefficient d'apodisation $A_R$ par rapport au facteur de réflexion local $R(x)$ supérieur ou égal à 1,1, le coefficient d'apodisation $A_R$ résultant, selon la formule (3)

$$A_R = \frac{Maximum\{R(x)\}}{Minimum\{R(x)\}} \quad (3),$$

du rapport entre une valeur maximale et une valeur minimale pour le facteur de réflexion local $R(x)$ du réseau (18).

**4.** Diode laser (100) selon la revendication 1, dans laquelle le réseau présente un coefficient d'apodisation $A_{\kappa L}$ par rapport au produit local du facteur de couplage et de la longueur $\kappa L$ supérieur ou égal à 1,1, le coefficient d'apodisation $A_{\kappa L}$ résultant, selon la formule (4)

$$A_{\kappa L} = \frac{Maximum\{\kappa L(x)\}}{Minimum\{\kappa L(x)\}} \quad (4),$$

du rapport entre une valeur maximale et une valeur minimale pour le produit local du facteur de couplage et de la longueur $\kappa L(x)$ du réseau (18).

**5.** Diode laser (100) selon la revendication 3 ou 4, dans laquelle l'épaisseur de réseau augmente de manière quadratique le long de l'axe longitudinal et le coefficient d'apodisation A est supérieur ou égal à 3.

**6.** Diode laser (100) selon l'une quelconque des revendications précédentes, dans laquelle le paramètre de couplage $P$ des différentes tranchées (24) est adapté à la densité de puissance de l'onde (26) guidée dans la zone de guidage d'ondes (12), le paramètre de couplage $P$ étant réduit dans les zones à haute densité de puissance par rapport au paramètre de couplage $P$ dans les zones à faible densité de puissance.

**7.** Diode laser (100) selon l'une quelconque des revendications précédentes, dans laquelle une variation $V_{dres}$ de la distance $d_{res}$ entre les différentes tranchées (24) et la couche active (10) est supérieure ou égale à 1,1.

**8.** Diode laser (100) selon l'une quelconque des revendications précédentes, dans laquelle une variation $V_{\Delta n}$ de la différence d'indice de réfraction $\Delta n$ entre l'indice de réfraction respectif d'une tranchée (24) individuelle et l'indice de réfraction du matériau entourant la tranchée (24) est supérieure ou égale à 1,1.

**9.** Diode laser (100) selon l'une quelconque des revendications précédentes, dans laquelle la longueur $L$ du réseau (24) est supérieure ou égale à 100 $\mu$m ou correspond à au moins 10 % de la distance entre la facette arrière (14) et la facette avant (16) le long du premier axe (X).

**10.** Diode laser (100) selon l'une quelconque des revendications précédentes, dans laquelle le réseau s'étend sur toute la longueur du résonateur ou est divisé en au moins deux parties de réseau, les au moins deux parties de réseau étant distribuées de manière arbitraire entre la facette arrière (14) et la facette avant (16) le long du premier axe (X).

**11.** Diode laser (100) selon la revendication 10, dans laquelle les tranchées (24) du réseau (18) se trouvent entièrement ou en partie dans des zones à gain optique ou sans gain optique.

**12.** Diode laser (100) selon l'une quelconque des revendications précédentes, dans laquelle la pluralité des tranchées (24) sont équidistantes, dans laquelle, pour au moins une des tranchées (24), une largeur $w$ de la tranchée (24) s'amincit en direction de la couche active (10) et/ou dans laquelle les parois des tranchées (24) présentent différents profils.

**13.** Diode laser (100) selon l'une quelconque des revendications précédentes, dans laquelle le paramètre de couplage $P$ des différentes tranchées (24) est dépendant du lieu le long d'un second axe (Y), qui s'étend perpendiculairement au premier axe (X), et le paramètre de couplage $P$ dépendant du lieu d'une tranchée (24) est adapté à la densité de puissance de l'onde (26) guidée dans la zone de guidage d'ondes (12), dans laquelle, dans les zones à haute densité de puissance, la valeur du paramètre de couplage $P$ dépendant du lieu de la tranchée (24) est réduite par rapport à la valeur du paramètre de couplage *P* dépendant du lieu de la tranchée (24) dans les zones à faible densité de puissance.

**14.** Procédé de fabrication d'une diode laser (100) comprenant :

- la fourniture d'une couche active (10) et d'une zone de guidage d'ondes (12) entourant au moins en partie la couche active (10) ;
- la formation d'une facette arrière (14) et d'une facette avant (16) conçue pour la sortie du rayonnement laser, la couche active (10) s'étendant au moins en partie le long d'un premier axe (X) entre la facette arrière (14) et la facette avant (16) ; et
- la formation d'un réseau (18) doté d'une pluralité de nervures (12) et de tranchées (24) de telle manière que le réseau (18) est en liaison fonctionnelle avec la zone de guidage d'ondes (24),

dans lequel il s'agit d'un réseau de surface et l'ordre du réseau se trouve dans la plage comprise entre 10 et 100, et

dans lequel la pluralité de tranchées (24) est réalisée de telle manière qu'une augmentation moyenne d'un paramètre de couplage *P* pour la pluralité des tranchées (24) le long du réseau (18) est différente de zéro, le paramètre de couplage *P* d'une tranchée (24) étant défini par la formule (5)

$$ P = \frac{\Delta n}{w d_{res}} \qquad (5), $$

où $d_{res}$ est une distance minimale entre un côté de la tranchée (24) orienté vers la couche active et un côté de la couche active (10) orienté vers la tranchée (24), *w* est une largeur de la tranchée (24) et $\Delta n$ est une différence d'indice de réfraction entre un indice de réfraction de la tranchée (24) et un indice de réfraction d'un matériau entourant la tranchée (24).

**15.** Procédé de fabrication d'une diode laser (100) selon la revendication 14, comprenant en outre :

l'application d'un masque de gravure (30) doté d'une pluralité d'ouvertures (32), sur la zone de guidage d'ondes (12), la largeur des ouvertures (32) variant localement le long d'un premier axe (X) et/ou le long d'un second axe (Y) ; et

la structuration de la zone de guidage d'ondes (12) masquée par un procédé de gravure.

Fig. 1     Stand der Technik

Fig. 2     Stand der Technik

Fig. 3a

Fig. 3b

a)

b)

c)

Fig. 4

a)

b)

Fig. 5

a)

b)

Fig. 6

Fig. 7

Fig. 8

Fig. 9

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6577660 B1

- JP H10223967 A

**In der Beschreibung aufgeführte Nicht-Patentliteratur**

- **CRUMP et al.** *J. Phys. D: Appl. Phys.*, 2013, vol. 46, 013001

- **DECKER et al.** *IEEE Photon. Technol. Lett.*, 2015, vol. 27, 1675